Europäisches Patentamt

European Patent Office

Office européen des brevets

(11) Veröffentlichungsnummer: **0 229 246 B1**

(12) # EUROPÄISCHE PATENTSCHRIFT

(45) Veröffentlichungstag der Patentschrift: **04.08.93**

(51) Int. Cl.⁵: **H03M 13/12**, //G06F11/10

(21) Anmeldenummer: **86115101.7**

(22) Anmeldetag: **31.10.86**

(54) **Verfahren zum Dekodieren von Binärsignalen sowie Viterbi-Dekoder und Anwendungen.**

(30) Priorität: **15.01.86 DE 3600905**

(43) Veröffentlichungstag der Anmeldung:
**22.07.87 Patentblatt 87/30**

(45) Bekanntmachung des Hinweises auf die
Patenterteilung:
**04.08.93 Patentblatt 93/31**

(84) Benannte Vertragsstaaten:
**DE FR GB IT**

(56) Entgegenhaltungen:
EP-A- 0 127 984
EP-A- 0 139 511
GB-A- 2 123 654
US-A- 4 240 156

IEEE TRANSACTIONS ON COMMUNICA-
TIONS. vol. 26, no. 10, Oktober 1978, NEW
YORK US Seiten 1463 - 1470; A.ACAMPORA:
"ANALOG VITERBI DECODING FOR HIGH
SPEED DIGITAL SATELLITE CHANNELS"

IEEE TRANSACTIONS ON COMMUNICATION
TECHNOLOGY. vol. 19, no. 5, Oktober 1971,
NEW YORK US Seiten 835 - 840; J. HELLER
ET AL.: "VITERBI DECODING FOR SATELLITE
AND SPACE COMMUNICATION"

IEEE NATIONAL TELECOMMUNICATIONS
CONFERENCE vol. 3, 1981, NEW YORK US
Seiten E171 - E174; R. ORNDORFF ET AL.:
"VITERBI DECODER VLSI INTEGRATED CIR-
CUIT FOR BIT ERROR CORRECTION"

G.C. Clark, J.B. Cain, "Error-Correction Coding for Digital Communications", Plenum
Press, New York, London, 1981, SS. 258-263

Hölzler, Holzwarth, "Pulstechnik", Band I, SS.
286-287

(73) Patentinhaber: **ANT Nachrichtentechnik GmbH**
**Gerberstrasse 33**
**W-7150 Backnang(DE)**

(72) Erfinder: **Heichler, Johannes, Dipl.-Ing.**
**Haselweg 8**
**W-7157 Murrhardt 3(DE)**

EP 0 229 246 B1

**Beschreibung**

Die Erfindung betrifft ein Verfahren zum Dekodieren von nach einem fehlerkorrigierenden Faltungscode aufbereiteten Binärsignalen, wobei durch Binäroperationen Zweigmetriken und hieraus wiederum Pfadmetriken gemäß der Viterbi-Dekodierung für die Empfangswahrscheinlichkeit der enkoderseitig gebildeten Quelldaten-Binärsignale ermittelt werden.

Bei der Übertragung von binären Datensignalen werden häufig fehlerkorrigierende Verfahren angewendet. Ein solches Verfahren bedient sich der Viterbi-Kodierung auf der Sendeseite und der entsprechenden Viterbi-Dekodierung auf der Empfangsseite. Bei der Viterbi-Kodierung/Dekodierung handelt es sich um eine sog. "Forward-Error-Correction", was bedeutet, daß keine Rückmeldung vom Empfänger zum Sender erfolgen muß. Dies ist insbesondere für die Datenübertragung mittels Satelliten vorteilhaft. Liefert die Nachrichtenquelle keine inhärenten, mit natürlicher Redundanz behafteten Signale, muß ein Korrekturkriterium in Form künstlicher, zeitlicher Redundanz der Kanalbits vorgesehen werden. Die Viterbi-Kodierung bedient sich der Faltungs-Kodes (Convolutional Codes), die aus einmaligen Quellsignal-Vorgängen zeitlich voneinander abhängende Informationsfolgen ableiten. Diese Informationsfolgen werden übertragen und auf der Empfangsseite entsprechend dekodiert.

In IEEE Transactions on Communication Technology, Band COM-19, No. 5, Oktober 1971, Seiten 835-848 ist das Viterbi-Dekodierverfahren aufgezeigt. Mittels eines Viterbi-Dekoders wird ein Pfad durch das Trellisdiagramm ermittelt, der zu einer Datensequenz führt, die der Quelldatensequenz möglichst ähnlich ist. Unter Zuhilfenahme der Pfadvorgeschichte werden die $2^{(K-1)}k$ wahrscheinlichsten Pfade durch das Trellisdiagramm gefunden (K: Konstraintlänge des Faltungscodes; k: Zahl der Eingangsdatenströme für den Faltungscode), wobei für jeden dieser Pfade die Metrik zu der empfangenen Datensequenz berechnet wird und wobei für jeden dieser möglichen Pfade des Viterbi-Algorithmus ein hypothetischer Quelldatenkanal zugeordnet wird.

Wenn das Datum für einen neuen Zweig in den Decoder eingegeben wird, wird jeder der abgespeicherten Pfade um einen Zweig verlängert. Um den benötigten Speicher zu begrenzen, wird aber jeder der abgespeicherten Pfade um einen Zweig (am Datenausgangsende) gekürzt. Vom höchstwahrscheinlichen Pfad wird dabei das Ausgangsdatum genommen. Bei jedem neuen Zweig wird dabei für einen Knotenpunkt im Trellisdiagramm nur ein überlebender Pfad "Survivor" beibehalten. Dies hat zur Konsequenz, daß die hypothetischen Bitdaten des jeweils überlebenden Pfades diejenigen des unterliegenden Pfades überschreiben (G.C. Clark and J.B. Cain, "Error-Correction Coding for Digital Communications", Plenum Press, New York, London 1981, Seiten 258 bis 263).

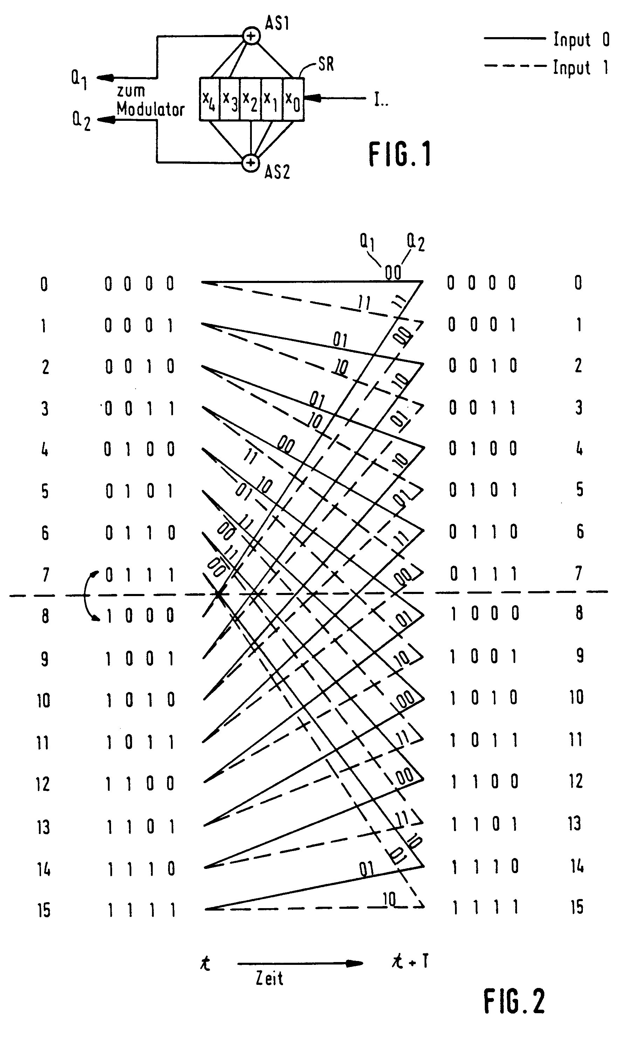

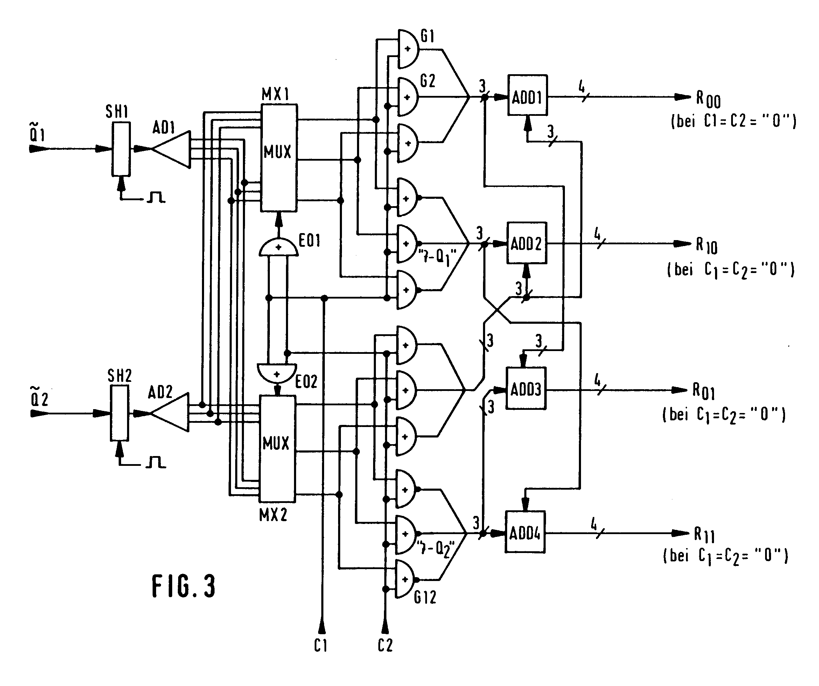

Für jeden Pfad im Trellisdiagramm wird eine Pfadmetrik berechnet (IEEE Transactions on Communication Technology, Vol. COM-19, No. 5, Oktober 1971, New York, J. Heller et al "Viterbi Decoding for Satellite and Space Communication", Seiten 835 bis 840;
US 4,240,156 insbesondere Fig. 2; National Telecommunications Conference, Vol. 3, 1981, New York, R. Orndorff et all "Viterbi Decoder VLSI Integrated Circuit for Bit Error Correction", Seiten E 1.7.1 bis E 1.7.4, insbesondere Fig. 3; GB-A-2123654, insbesondere Fig. 4); wobei ein Extrem der Pfadmetrik ein Zeiger auf den wahrscheinlichsten Pfad ist. Aus rechentechnischen Gründen - Verhinderung eines Überlaufs - wird üblicherweise die Pfadmetrik regelmäßig normalisiert (US 4,240,156, insbesondere Fig. 2; GB-A-2123654, insbesondere Fig. 4);
Die aus vorgenannten Veröffentlichungen bekannten Dekoder bestehen aus Netzwerken mit Entscheidungslogiken und Rechenwerken zur Ermittlung von Zweig- und Pfadmetriken gemäß den Gesetzmäßigkeiten der Viterbi-Dekodierung, Registern und Pufferspeichern zur Zwischenspeicherung von Pfadmetrik-Informationen sowie Ausgangseinheiten zur Abgabe der dekodierten Binärsignale anhand von Entscheidungskriterien (IEEE National Telecommunications Conference, s.o., Fig. 1 und 3). In dem aus vorgenannter Veröffentlichung bekannten Dekoder sind im ACS (add-compare-select)-Netzwerk viele Gatterebenen vorhanden, die zu hohen Signallaufzeiten und dementsprechenden Verzögerungen führen. Auch die aus den anderen vorgenannten Dokumenten bekannten Dekoder weisen solche Signallaufzeiten auf mit der Folge, daß das Metrikminimum mehrdeutig ist und keine Echtzeitverarbeitung möglich ist.

Aufgabe der Erfindung ist es, das Verfahren eingangs genannter Art für einen einfachen Signalfluß mit möglichst realzeitmäßiger Verarbeitung, d.h. zeitgleicher Auswertung der Binärsignalzustände pro Taktschritt, weiterzubilden. Außerdem soll ein Viterbi-Dekoder aufgezeigt werden sowie eine Einrichtung für einen Viterbi-Dekoder zum Berechnen der Pfadmetriken. Anwendungen dieses Dekoders, bzw. der Einrichtung sollen ebenfalls aufgezeigt werden. Diese Aufgabe wird bezüglich des Verfahrens durch die Schritte des Anspruch 1 gelöst.

Anspruch 2 betrifft einen Viterbi-Dekoder. Der Anspruch 3 gibt eine Weiterbildung eines solchen Dekoders an und Anspruch 4 behandelt eine Einrichtung für einen Viterbi-Dekoder zum Berechnen der Pfadmetriken. Die Ansprüche 5 und 6 zeigen Anwendungen.

Die Erfindung besitzt folgende Vorteile:

Die Struktur der Signalverarbeitung ist sehr übersichtlich und damit leicht kaskadierbar im Gegensatz zu einigen der eingangs genannten Realisierungsmöglichkeiten. Eine hochgeschwindigkeitsfähige Implementation ist gegeben. Die Signalverarbeitung geschieht sehr laufzeitarm.

Der Dekoder nach Anspruch 2, bzw. die Einrichtung nach Anspruch 4 bringt auch hinsichtlich der Anwendung bei bereits bekannten Dekodierverfahren Vorteile, insbesondere was die Signallaufzeiten betrifft.

Anhand der Zeichnungen wird die Erfindung nun näher erläutert. Es zeigen:

Fig. 1 einen Convolutional-Enkoder,

Fig. 2 ein Trellis-Diagramm,

Fig. 3 die Eingangssektion eines Dekoders,

Fig. 4 das Aufbauprinzip der Netzwerke zum schnellen Ermitteln der kleinsten Pfadmetrik,

Fig. 5 das Prinzip der Metrik-Auswertung unter Verwendung von Barrel-Shift-Matrizen,

Fig. 6 das Prinzip der Metrik-Auswertung in halbarithmetischer Ausführung,

Fig. 7 das Prinzip der Path-Memory Ansteuerung

Fig. 8 eine alternatives Prinzip des Datentausches bei Verzweigungen im Trellis-Diagramm,

Fig. 9 eine Wertetafel zur Umkodierung des Entscheidungssignals,

Fig. 10 das Verbindungsschema zwischen den ACSS-Netzwerken und den Adreßprozessoren,

Fig. 11 das Verbindungsschema für die Sonderfälle von Verzweigungen im Trellis-Diagramm,

Fig. 12 eine Schaltungskonfiguration zur Zwangsumschaltung

Fig. 13 die Gesamtschaltung des Dekoders,

Fig. 14 eine Wahrheitstafel für das Datenfluß-Richtungssignal bei einer Verzweigung im Trellis-Diagramm,

Fig. 15 den Aufbau der Datenausgabeeinheiten und

Fig. 16 die Adreßprozessoren mit Multiplexern.

Vor der eigentlichen Beschreibung des Dekodierverfahrens sowie der Anordnungen werden einige allgemeine Zusammenhänge und Begriffe der Viterbi-Kodierung/Dekodierung erläutert auf die später Bezug genommen wird.

Zunächst ist in Fig. 1 schematisch ein Convolutional-Enkoder dargestellt. Dieser Enkoder besteht aus dem Schieberegister SR mit parallelen Datenzugängen zu seinen einzelnen Zellen. Die Quellinformation Q wird von links in dieses Register SR geschoben. Im vorgestellten Beispiel beträgt die Zellenzahl K = 5, die auch "Konstraint-Länge" genannt wird und eine wesentliche Aussage über die Art des "Convolutional Codes" darstellt. Die parallel zugänglichen Daten werden, bei dem hier beschriebenen Code zweimal nach bestimmten Gesetzen, den sogenannten "Generatorpolynomen" verknüpft. Die Operation der Verknüpfung ist bei allen Convolutional Codes die Modulo-zwei-Addition, schematisch dargestellt durch die beiden Addierstufen AS1 und AS2, im "Galios-Körper" der binären Zahlen. Veranschaulichen kann man sich diese Operation als "Parity-Check": Eine gradzahlige Addition der binären "1" ergibt stets eine binare "0", während ungradzahlige Kompositionen stets wieder die "1" ergeben. Auf dieser Grundlage sind die oberhalb und unterhalb des Schieberegisters entstehenden Kanalbits zu sehen, die der Empfänger, vermischt mit Störungen aller Art, erhält. Die Viterbi-Dekodierung verfolgt nun die Grundidee, die endliche Anzahl der Zellen im Schieberegister in einen Zusammenhang mit der oben beschriebenen modulo-zwei-Verkoppelung zu setzen, wobei sie die Abhängigkeit eines gerade neu entstehenden Bitpaares (Dibits") von dem Vorgeschehen ausnutzt.

In dem hier geschilderten Fall erreichen den Empfänger die mehr oder weniger gestörten Bitpaare auf dem Wege zweier Kanäle, wobei es wegen der Störungen häufig nicht klar ist, ob im Einzelfall eine binäre "0" oder eine "1" empfangen wurde. Die zu den Datenströmen gehörigen Spannungen können somit beliebige Zwischenwerte annehmen. Diese Unsicherheit wird zunächst mit Hilfe der sogen. "Soft-Decision" erfaßt. Sie versteht die empfangenen Signale zunächst als Analogwerte, die mit Hilfe einer A/D-Wandlung in n Stufen quantisiert werden. Hier ist eine Quantisierung in 8 Stufen vorgesehen, was einer A/D-Wandlung mit je 3 Bit pro Kanal entspricht.

Da zu jedem Quellbit ein Bitpaar auf dem Kanal gehört, besteht grundsätzlich die Möglichkeit zu vier Kombinationen in einem Bitpaar. Entsprechend dieser Kombination werden vier Rechengrößen erzeugt, deren Wert ein Maß für die Wahrscheinlichkeit einer empfangenen Zweibit-Kombination ist.

Seien Q1 und Q2 die quantisierten, 8-stufigen Signalwerte, dann setzen sich die vier Rechengrößen wie folgt zusammen:

$$R_{00} = Q1 + Q2$$
$$R_{01} = Q1 + 7 - Q2$$
$$R_{10} = 7 - Q1 + Q2$$
$$R_{11} = 7 - Q1 + 7 - Q2$$

Es ist ersichtlich, daß bei eindeutigem Empfang eines ungestörten Dibits eine der vier Größen (man nennt sie "Zweigmetriken") Null wird, und zwar genau jene der Größen, die entsprechend indiziert ist.

Sei beispielsweise ein Dibit "01" empfangen worden, dann wird Q1 = "0", Q2 = "7" und entsprechend $R_{01}$ = 0.

Interessant ist dabei das Verhalten der drei anderen Werte: $R_{00}$ = 7, $R_{11}$ = 7, $R_{10}$ = 14.

Deutlich tritt hervor, daß in diesem Falle $R_{10}$ den Charakter eines Extremwertes angenommen hat, während die Gleichheit der beiden anderen mit gleicher (Un-) Wahrscheinlichkeit korreliert.

Mit jedem empfangenen Dibit stehen also vier Rechenwerte aus der Soft-Decision-Stufe zur Verfügung, die ein Maß für den Abstand zum real empfangenen Signal darstellen. Bei einem gestörten Signal ist unmittelbar anschaulich klar, daß es keinen "idealen" Wert "0", aber ebensowenig einen "extremen" Wert "14" geben würde, da es am Eingang der A/D-Wandler durch die Störungen zusätzliche Spannungswerte gäbe.

Je stärker z.B. das Rauschen, um so nivellierter erscheint das "Gebirge" dieser Zweigmetriken, rauscht es nur, liegen alle bei einem Mittelwert.

Die Viterbi-Kodierung/Dekodierung beruht nun auf der weiteren Verarbeitung dieser vier Rechengrößen derart, daß er ein aus vielen Dibits bestehendes, längeres Informationsmuster aus den Störungen heraushebt, indem er die Größen ständig aufsummiert und nach einer hinreichenden Anzahl von Summationen eine Entscheidung über die eigentliche Quellinformation ausgibt.

Dabei ist zu beachten, daß das Gesetz des Schieberegisters gilt und gleichzeitig die oben genannten modulo-zwei-Verknüpfungen existieren (Fig. 1). Das Gesetzt des Schieberegisters liefert wegen der Anzahl seiner Zellen naturgemäß eine größere Vielfalt an Zuständen, als es bei der Dibit-Kombination der Fall ist. Hierzu sei noch einmal Fig. 1 betrachtet: Die vier (oder allgemeinen : K-1) Zellen der niederwertigen Bits definieren den sogen. "State" oder "Zustand" des Registers. Dabei ist das so entstehende Binärwort als binär codierte Zahl zu lesen, wobei das niedrigstwertige Bit an der Stelle steht, wo die Quellinformation hineingeschoben wird. Steht beispielsweise in den vier State-Zellen die "1010" = 5, dann wird daraus durch das Hineinschieben einer "0" die "0101" = 10, und durch das Hineinschieben einer "1" die "1101" = 11.

Wie man sieht, entspricht diese Operation im ersten Fall einer Multiplikation mit "2", im zweiten Fall auch, mit dem Unterschied, daß zusätzlich noch "1" addiert wird.

In gleichem Maße, wie neue Quellbits über das L.S.B. in das State-Fenster - dick umrahmte Zellen - gelangen, verschwinden sie daraus über das M.S.B. - ganz rechts. Stand vorher eine Zahl im Fenster, die größer als 8 war, so muß man, um nach dem Shift das richtige Ergebnis zu erhalten, diese "8" vor dem Shift subtrahieren. Als Beispiel: Stand vorher die "0101" = 10 im Fenster, so erhält man nach dem Shift für das Nachschieben einer "1" : 1010 = 5. Es ergeben sich also im Laufe des Schieberegister-Prozesses Zweideutigkeiten, die der Empfänger freilich nicht kennt, und die er auf Grund seiner Metrik-Summation ausschließen muß. Hierbi nimmt die Viterbi-Dekodierung die empfangenen Dibits zu Hilfe.

Fig. 2 zeigt das in der einschlägigen Literatur häufig zitierte "Trellis-Diagramm", das nichts anderes wiedergibt als die oben beschriebene Schieberegister-Funktion für die Zellen-Anzahl von K = 5. Mit dem reduzierten State-Definitionsfenster ergeben sich somit sechzehn verschiedene States, die als Start- oder Endpunkt auftreten können. Auch eine Symmetrielinie bei der "8" ist eingezeichnet. An die Übergangslinien zwischen den Zuständen sind die mit dem hier verwendeten Code korrespondierenden Dibit-Kombinationen notiert. Sie hängen in der Tat nur mit dem verwendeten Code zusammen, d.h. mit der beschriebenen modulo-zwei-Verkopplung: Bei dem Gesetz der Schieberegister-Funktion war von ihnen keineswegs die Rede. Es fällt bei der Betrachtung der Zuordnung auf, daß die Dibit-Kombinationen vor allem gleichverteilt sind, d.h. auf den insgesamt 32 Ästen kommt jede von ihnen nur achtmal vor.

Weiterhin fällt auf, daß Verzweigungen nur über gegensätzliche Dibits erfolgen. Die dazugehörigen Rechenwerte der Zweigmetriken werden daher extrem gegensätzlich sein.

Würde man die Verzweigungen bei jedem Schritt jedesmal alle berücksichtigen, ergäbe sich eine baumartige Vervielfältigung der Übergangsmöglichkeiten. In diesem Zusammenhang sei noch einmal erwähnt, daß der Viterbi-Empfänger grundsätzlich den Anfangszustand im Enkoder des Senders nicht kennt und aufgrund dessen möglichst viele potentielle Zustände des senderseitigen Schieberegisters "annehmen" muß.

Die obengenannte baumartige Vervielfachung der Zustände würde jedoch zwangsläufig stets zu Kapazitätsüberschreitungen am Empfangsort führen und nach wenigen Schritten wäre es bereits unmöglich, den Dekodierungsprozeß fortzuführen.

Abhilfe schafft hier der ebenfalls obengenannte Extremwertcharakter des zugeordneten Dibit-Codes:

Als Beipiel sei der Übergang von der "0" im State-Fenster zu wiederum der "0" genommen. Wie man dem Trellis-Diagramm entnimmt, kann die "0" jedoch auch aus der "8" entstanden sein! Die durch die Generator-Polynome erzeugten Dibits, und damit deren Zweigmetriken, zeigen aber Extremwertcharakter. Wurde z.B. real das Dibits "00" empfangen, ist - wie bereits erläutert - die Zweigmetik $R_{00}$ = 0, dagegen $R_{11}$ = 14. Die Apparatur kann nun hieraus schließen, daß der Übergang "0 - 0" höchstwahrscheinlich vorgelegen haben muß, der Übergang "8 - 0" hingegegen wegen extremer Unwahrscheinlichkeit ausgeschlossen werden kann.

Derartige Gesetz gelten - wie man sich an Hand des Trellis-Diagramms leicht erläutern kann - für jede Verzweigung. Das ist auch die Begründung, weshalb der gewählte Code nicht willkürlich ist, sondern hinsichtlich dieser spiegelbildlichen Charakteristik optimale Eigenschaften besitzt. In diesem Zusammenhang sei erwähnt, daß es auch sogennante "Catastrophic-Codes" gibt, deren Viterbi-Decodierung instabil verläuft, d.h. nach einiger Zeit grundsätzlich falsche Quellbits ausgibt. Es ist anschaulich, daß ein fehlender Extremwertcharakter, wie er oben beschrieben wurde, mehr Instabilität zur Folge hätte als der gewählte, optimale Code.

Diese Prozedur des Ausschlusses unwahrscheinlicher Baumzweige ist ein elementarer Bestandteil der Viterbi-Dekodierung, sie macht sein Realisierung in der Praxis überhaupt erst möglich. So entstehen nach jedem Schritt oder, wie es auch heißt, in jedem "Trellis-Segment", aus 16 Zuständen wiederum 16 und die Anzahl der möglichen Zustände bleibt stets konstant.

Im Laufe der Dekodierung werden diesen 16 verschiedenen Zuständen Summenwerte zugeordnet, die sich aus den Zweigmetriken zusammensetzen, die während dieser Dekodierung benutzt worden sind. Auch der Ausschluß eines unwahrscheinlichen Zweiges wird grundsätzlich unter Berücksichtigung der "Vergangenheit", d.h. der zugehörigen Summe, vorgenommen, und nicht etwa anhand der aktuellen Extremwert-Zweigmetrik allein. Sei beispielsweise wieder der Übergang "0 - 0" betrachtet: Die Summe aus vorhergehenden Entscheidungen sei hier z.B. "10" für den alten Zustand "0". Der alte Zustand "8" sei aus seiner Vergangenheit heraus mit einer Summe "5" behaftet gewesen. Es sei wiederum der reale Empfang eines Dibits "00" angenommen. Dann führt die Apparatur folgende Operation durch: Es wird die "0"-Summe genommen und auf sie die Zweigmetrik $R_{00}$ addiert, die streng zu diesem Übergang "0 - 0" gehört, wie man dem Trellis-Diagramm entnehmen kann.

Als Nächstes wird die alte "8"-Summe herangezogen und auf sie die ebenfalls mit dem Übergang "8 - 0" streng verkoppelte Zweigmetrik $R_{11}$ addiert. Die Ergebnisse betragen dann:

$$S_0 = 10 + 0 = 10 \; ; (R_{00} = 0)$$
$$S'_0 = 5 + 14 = 19 \; ; (R_{11} = 14)$$

Als Nächstes vergleicht die Apparatur diese beiden Summen und wählt die kleinere zur Abspeicherung und Trellis-Entscheidung aus. Die größere wird verworfen. In diesem Falle würde der Übergang "0 - 0" favorisiert und für die neue "0"-Summe eine "10" abgespeichert! An Stelle der Bezeichnung "0"-Summe soll von nun an der Begriff "Pfadmetrik 0" verwendet werden, der auch in der Literatur hierfür üblich ist. Man betrachtet bei der Aufsummierung und Entscheidungsfällung folgendes: Die Wahl des "überlebenden" Zweiges hängt extrem stark von der Pfadmetrik, also dem bereits aufsummierten, ab, so daß dem gegenüber die aktuelle Zweigmetrik in den Hintergrund treten kann! Im obigen Beispiel war das "$R_{00}$" wegen der kleinen Vorsummen relevant. Im Laufe einer langen Aufsummation kann jedoch leicht der umgekehrte Fall eintreten: Eine Pfadmetrik ist so groß geworden, daß sie von der Apparatur stets als "schlechter" ausgeschieden wird, gleichtültig, wie groß das aktuelle R auch ausfällt. Auf der anderen Seite bildet sich bei langem, störungsfreiem Empfang eine minimale Pfadmetrik heraus, so daß eine zeitweilige Überhöhung der aktuellen Zweigmetrik dadurch aufgefangen wird. Es ergibt sich hieraus:

Die Pfadmetrik hat stets ein größeres Gewicht als die aktuelle Zweigmetrik, sie stellt eine bevorzugte Minimalsumme aus zahlreichen "guten" Zweigmetriken der Vergangenheit, also eines ganzen "Pfades", dar.

Eben hierin besteht die Fähigkeit der Viterbi-Kodierung/Dekodierung, die künstliche Kanalredundanz ausnutzen und auftretende Übertragungsfehler zu korrigieren.

Bisher ist nur von dem Mechanismus die Rede gewesen, der unter den Übergängen der Schieberegister-Funktion den wahrscheinlichsten auswählt. Es muß noch diskutiert werden, wie letztendlich das übertragene Quellbit erhalten wird.

Wie oben erläutert, gehen mit 16 verschiedenen, in jedem Schritt neu erzeugten Schieberegisterzuständen 16 verschiedene Pfadmetriken einher, deren "Wertgebirge" ein recht präzises Maß für den wahrscheinlichsten, senderseitigen Schieberegisterprozeß darstellt. Weiterhin wurde klar, daß in den hier verwendeten Prozeduren große Wahrscheinlichkeiten mit minimalen Werten der Metriken einhergehen. Die folgende Aufgabe besteht somit darin, unter den 16 Pfadmetriken die minimale auszuwählen und den dazugehörigen Trellisprozeß bis zu dem Anfangspunkt zurückzuverfolgen, von dem ab die Summation begonnen wurde. Das zu diesem Zeitpunkt in das Schieberegister hineingeschobene Quellbit kann als wahrscheinlich dekodiert, d.h. ausgegeben werden. Damit ist die Viterbi-Dekodierung für einen Zeitschritt beendet. Der folgende Ablauf ist analog: Die aktualisierten Pfadmetriken werden erneut zum addieren und vergleichen herangezogen, weshalb dieser Prozeß in der Literatur auch ACS ( = ADD-COMPARE-SELECT) genannt wird. ("SELECT" für die dann folgende Auswahl der kleineren Metrik).

Nachfolgend wird nun ein beispielhafter Dekoder beschrieben, anhand dessen die einzelnen Verfahrensschritte erläutert werden. Die einzelnen Baugruppen des Dekoders werden in der Reihenfolge des Informationsflußweges vorgestellt.

Die Eingangssektion des Viterbi-Dekoders ist in Fig. 3 dargestellt. Diese Eingangssektion hat die Aufgabe die an sich bekannte Soft-Decision, vgl. beispielsweise EP 52 463 A1, mit Hilfe von A/D-Wandlern sowie eine Umschaltung der quantisierten Dibits für Synchronisationszwecke vorzunehmen. Die Eingangssignale Q1 und Q2, die parallel auf dem Übertragungsweg übertragen wurden, gelangen zuerst auf zwei taktgesteuerte Sample-and-Hold-Glieder SH1 und SH2. An diese Sample-and-Hold-Glieder schließt sich jeweils ein A/D-Wandler AD1, bzw. AD2, an mit 3-Bit-breiten Ausgängen. Die Quantisierung beträgt demzufolge im vorgestellten Ausführungsbeispiel 8 Stufen. Für den Fall eines-Träger-Phasensprunges bei einer 4-PSK-Übertragung, muß die Umwertung der Bits rückgängig gemacht werden. Dabei muß aber nicht nur die auftretende Inversion eines Bits im Falle eines $\pm$ 90°-Phasensprunges kompensiert werden, sondern auch die dann auftretende Vertauschung. Hinter den A/D-Wandlern AD1 und AD2 werden deshalb die Kanäle mit Hilfe der Multiplexer MX1 und MX2 kreuzweise vertauschbar gemacht. Eine einfache Logik ermöglicht dann die Realisation des Transformationsgesetzes der Koordinatendrehung.

Beispiel: **Phasensprung + 90°**

Vertauschung:
sin $(\beta) \rightarrow$ cos $(\beta)$ entsprechend Q1 $\rightarrow$ Q2
cos $(\beta) \rightarrow$ -sin $(\beta)$ entsprechend Q2 $\rightarrow$ -Q1

**Phasensprung -90°**

Vertauschung:
sin $(\beta) \rightarrow$ - cos $(\beta)$ entsprechend Q1 $\rightarrow$ - Q2
cos $(\beta) \rightarrow$ sin $(\beta)$ entsprechend Q2 $\rightarrow$ Q1

**Phasensprung 180°**

nur Invertierung, jedoch keine Vertauschung.

Die beiden Multiplexer MX1 und MX2 werden über jeweils ein EX-OR-Glied EO1, bzw. EO2, von den Steuersignalen C1 und C2 gesteuert. Diese Steuersignale können auf einfache Weise aus den Synchroneinrichtungen abgeleitet werden. Die Synchroneinrichtungen, hier nicht dargestellt, erkennen den Anstieg der Metrik, d.h. Auftreten unzulässiger Codes und Phasensprünge. Die 3-Bit-breiten Ausgänge jedes Multiplexers werden jeweils einmal entsprechend der Zahl der Quantisierungsstufen auf EX-OR-Gatter G1, G2, G3, bzw. G7, G8, G9, und einmal auf EX-NOR-Gatter G3, G4, G5 bzw. G10, G11, G12 geführt. Die Gatter G1 ... G12 werden über ihre Steuereingänge, die mit den Steuersignalen C1 und C2 beaufschlagt sind, kontrolliert. Die Steuersignale C1 und C2 bewirken, daß aus den Gattern G1 ... G12, die als Inverter ausgebildet sind schaltbar Nichtinverter realisiert werden können und entsprechend aus den Nichtinverten Inverter.

Mit dieser Ausbildung werden gleichzeitig zwei Effekte in laufzeitarmer Realisation erzielt: Die quantisierten Größen Q1 und Q2 stehen jeweils einmal nichtinvertiert und invertiert zur Verfügung, wobei die Invertierung mit Hilfe der Steuersignale C1 und C2 kontrolliert wird. Zum anderen bewirkt diese Invertierung auf einfachste Weise die Ausführung der Rechenoperation "7 - Qi", da sie genau des Einerkomplement der Größen Qi bildet. Es wird durch diese Inversion eine Rechenoperation eingespart. Die so verarbeitete Information braucht jetzt nur noch vier Volladdierern ADD1 ... ADD4 zugeführt werden, wobei die Verknüpfung entsprechend der bereits vorgestellten Beziehungen für die Zweigmetriken $R_{00}$, $R_{01}$, $R_{10}$, $R_{11}$ zu erfolgen hat.

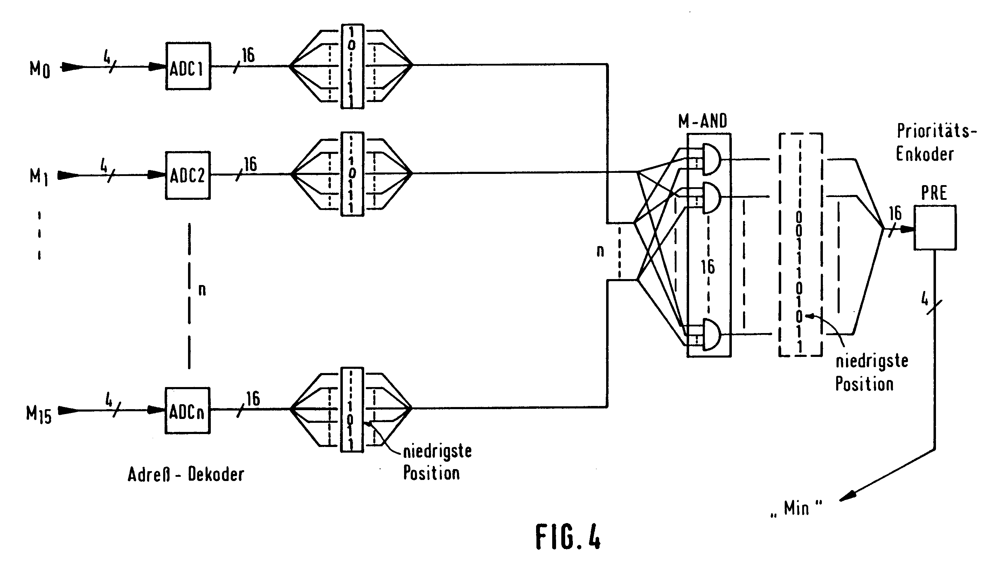

Die Ausgänge der Eingangssektion sind mit Netzwerken zum Addieren und Vergleichen der Metriken verbunden. Das Aufbauprinzip solcher Netzwerke ist in Fig. 4 dargestellt. Die Addition und das Vergleichen wird mittels Transformation der Rechenoperation vom arithmetischen in den logischen Operationsbereich ausgeführt, was einer strengen Parallelisierung gleichkommt. Der ACS-Prozeß (add-compare-select) kann daher mit hoher Geschwindigkeit ausgeführt werden. Schnelle Adressdekoder und Multiplexer sowie schnelle Prioritätsenkoder erlauben die Darstellung einer Binärzahl als Position eines logischen Zustandes in einer Zeile von $2^n$ Bits, wobei n die Stellenzahl der Binärzahl ist. Befindet man sich vor diesem Hintergrund im Bereich der logischen Binäroperationen, so leuchtet ein, daß eine Addition durch einen SHIFT der $2^n$ Bits, und das Auffinden der kleinsten Zahl einer Zahlenmenge durch das parallele UND bzw. ODER-Verknüpfen der so transformierten Zahlen möglich wird. In der Wahl der positiven bzw. negativen Logik ist man dabei frei. Fig. 4 zeigt das Prinzip des Verfahrens. Zunächst die Operation "Vergleichen": Mehrere z.B. vier Bit breite Binärzahlen der Metriken M0 ... M15 werden zunächst mit Hilfe der Adreß-Dekoder ADC1 ... ADCn als Bitposition dargestellt. Das kann beispielsweise eine logische "0" inmitten 15 logischer "1"'en sein. Anschließend wird jedes der 16-Bit-Arrays dem Multi-Und-Gatter M-AND zugeführt, wo alle Bit für Bit entsprechend der UND-Funktion verknüpft werden. Das Ergebnis ist wiederum ein 16-Bit-Array, das alle logischen "0"-Zustände mit ihren Positionen gesammelt hat. Ein Prioritäts-Enkoder PRE gibt, dahintergeschaltet, die Position der NIEDRIGSTEN "0" als Binärzahl aus. Sie entsprach aber umgekehrt der niedrigsten Binärzahl am Eingang des entsprechenden Adreß-Dekoders ADC1 ... ADCn. Prioritätsenkoder dieser Art können aus Standardbausteinen aufgebaut werden, z.B. aus 2 74F148 ICS. Die Zusammenschaltung für einen "16-line-to-4-line binary encoder" aus zwei dieser Standardbausteine ist aus The TTL Data Book, Supplement to CC-401, 2. Auflage, Texas Instruments, Seite 293 bekannt, oder aus dem FAST-DATA-Book. Die Operation des Vergleichens kommt innerhalb der Viterbi-Dekodierung an zwei bedeutungsmäßig verschiedenen Stellen vor, nämlich zunächst bei der Zweigwahl im Trellis-Segment, und schließlich beim Erkennen der minimalen Metrik der 16 Pfade kurz vor der Ausgabe der dekodierten Bits. Da bisherige Lösungsversuche sehr aufwendig anmuteten (z.B. mit einem ganzen "Baum" von arithmetischen Vergleichern und entsprechenden Laufzeitproblemen ergeben sich für die vorgestellte Realisierung Vorteile insbesondere wegen seiner gleichförmigen Struktur und seiner VLSI Freundlichkeit.

Die Operation "Addieren" erfordert in der logischen Ebene besondere Bausteine mit einer Breite von 16 Bit. In Bezug auf eine VLSI-Integration ist dieses Verfahren interressant, insbesondere hinsichtlich der Technik der "Barrel"-Shift-Matrizen. Derartige Bauelemente benötigt nämlich das Addierwerk, da es in High-Speed, d.h. asynchron und ohne Flip-Flops, ein 16 - Bit Wort um maximal 16 Bit nach Maßgabe einer 4 - Bit Binärzahl verschieben können muß. In ECL-Technik kann auf ein solches Bauelement mit 8 Bit Verarbeitung zurückgegriffen werden.

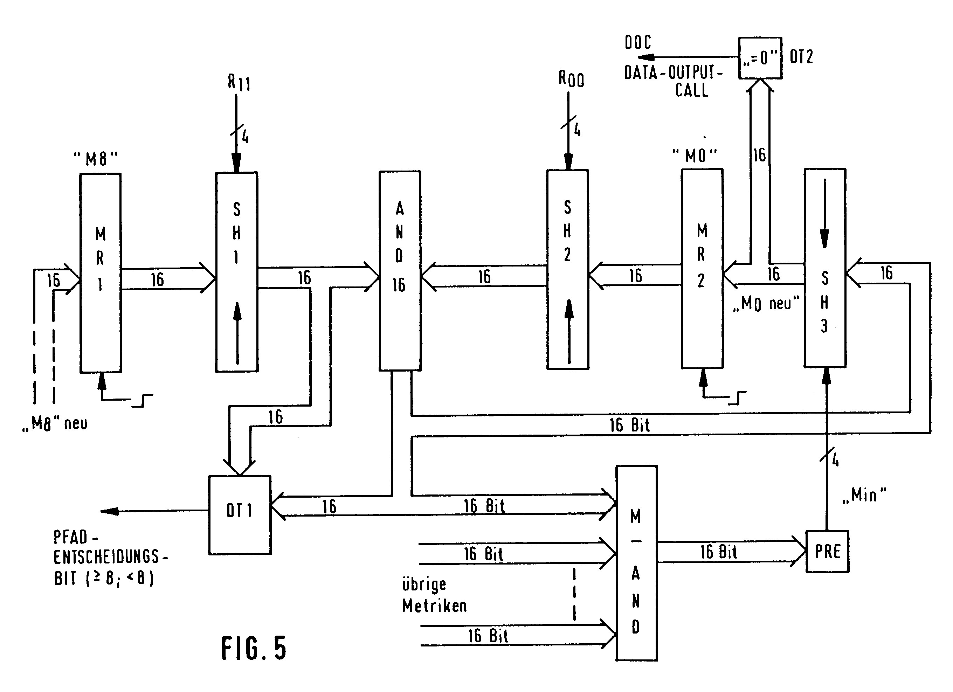

Das "Barrel-Shift-Addierverfahren" wird nun anhand von Fig. 5 erläutert. Es stellt einen kürzeren Signalflußweg im ACS-Werk dar und ist somit laufzeitärmer als eine halbarithmetische Realisierung. Fig. 5 zeigt das Prinzip der Metrik-Auswertung unter Verwendung von 16 Bit breiten Shift-Matrizen. Auch die oben beschriebene Schaltung zur Auffindung der minimalen Matrik ist bereits eingeflochten. Wieder wird das Beispiel des Trelliszweig-Überganges "0-0" bzw. alternativ dazu "8-0" benutzt. Die aus der Eingangssektion stammenden Zweigmetriken $R_{00}$ und $R_{11}$ stehen oben an zwei 16 - Bit Shift-Matrizen SH1, SH2 gleichzeitig zur Verfügung. Beide Matrizen erhalten ihre 16 - Bit Arrays aus zwei ebenso breiten Registern MR1 und MR2, die hier als logisch transformierte Metrik-Register fungieren. Die aus dem rechten Register stammende Metrik "MO" wird also mit Hilfe der Shift-Matrix um genau $R_{00}$ Stellen verschoben und dem 16-fach-UND-Element AND 16 zugeführt. Ein Gleiches geschieht mit der Metrik des linken Registers, nur, daß jetzt $R_{11}$ die Stellenverschiebung bewirkt. Was die UND-Funktion bewirkt (Stufe AND16), wurde oben bei der Auswahl der minimalen Metrik bereits beschrieben: Es wird hier die Position der logischen "0" zunächst gesammelt. Das so entstehende 16-Bit-Array wird nun zwei weiteren Stufen zugeführt: Zum einen der bereits bekannten Multi-AND-Stufe M-AND zur Bestimmung der minimalen Matrix, zum anderen einer weiteren Shift-Matrix SHM3 am Eingang des Metrik-Registers MR2, die aber nun die Aufgabe hat, das Bitmuster um einen gewissen Betrag zurückzuschieben. Wie man aus der Schaltung leicht ersieht, ist das genau der Betrag der minimalen Metrik, von einem Prioritäts-Enkoder PRE detektiert, der den Rück-Shift bewirkt.

Arithmetisch gesprochen heißt das: Von jeder Metrik wird die minimale abgezogen, um einen Überlauf der Speicher zu verhindern. Somit wird die minimale Metrik stets in jedem Schritt zu Null subtrahiert, und die anderen sind genau um den Betrag der minimalen Metrik kleiner als vorher. Man beachte, daß das in dieser Schaltung alles asynchron, d.h. ohne Zwischentaktschritte und daher extrem laufzeitarm geschieht. Lediglich die Neuspeicherung in den Registern muß mit einer Taktflanke erfolgen, was aber bei Speicherelementen selbstverständlich ist. Da das hier vorgestellte Netzwerk die ACS-Operation in einem Schritt mit der Minimal-Subtraktion verbindet, soll es als ACS-S("Add-Compare-Select-Subtract)-Rechenwerk bezeichnet werden.

Das ACS-Rechenwerk des hier entwickelten Viterbi-Dekoders ist demzufolge in seiner Arbeitsweise vor allem dadurch charakterisiert, daß die arithmetischen Operationen "Addieren" und "Subtrahieren" ersetzt werden durch logische Shift-Operationen, wobei am Shift- In - Ort neutrale Zeichen - je nach Vorzeichen der Logik - nachgeschoben werden. Weiterhin ist es dadurch charakterisiert, daß die Bestimmung eines Extremwertes (hier im Beispiel: Minimum) im logischen Bereich durch einfache UND- bzw. ODER-Verknüpfungen - je nach Vorzeichen der Logik - erfolgt.

Die Ableitung der Information für Trellis-Memory-Management (Entscheidung über den State-Wechsel, Output-Information) und Output-Device ist lediglich eine schaltungstechnische Frage. Es muß dabei detektiert werden, ob die Metrik aus dem "linken" oder "rechten" Register samt ihrer Aufaddition, vgl. Fig. 5, "überlebt" hat und woher die minimale Metrik stammt, d.h. in welchem Register sie letztendlich abgespeichert wurde. Ersteres müßte mit einem Positionskomparator, zweiteres durch eine "Null"-Erkennung in den Registern erfolgen. Diese Prozeduren sollen jedoch nicht Gegenstand einer Spezifikation sein, zumal sie auch von den verfügbaren Bauelementen stark abhängen.

Als Output liefert das ACS-S-Werk grundsätzlich zwei wie folgt definierte Schnittstellen-Informationen in Richtung auf das Trellis-Management:

1) Das Pfadentscheidungsbit mit einer logischen "1" für einen vergangenen Zustand, der größer oder gleich 8 war. (Entsprechend einer "0" für States kleiner als 8).

2) Das Data-Output-Call-Bit mit einer "1" für eine Ausgabe aus dem entsprechenden Trellis-Memory.

Es versteht sich von selbst, daß diese Vorzeichenfestlegung keinesfalls zwingend ist, sondern als Beispiel zu verstehen ist. Je nach verfügbaren Bausteinen kann nämlich positive oder negative Logik notwendig werden.

Beide Informationsbits stehen für den hier beschriebenen Fall einer Konstraint-Length von 5 (5 Zellen im senderseitigen Entkoder) 16 mal zur Verfügung, da es insgesamt 16 ACS-S-Werke gibt. Sie müssen anschließend im Trellis-Memory-Management weiterverarbeitet werden.

Zur Ausgabe eines Pfadentscheidungsbits ist eine Pfadentscheidungsbitdetektor DT1 vorgesehen, welcher die Eingangs-und Ausgangsdaten der AND16-Stufe auswertet. Ein Data-Output-Call-Bit wird durch den Minimalmetrikdetektor DT2 ausgegeben, welcher von den Daten in der Rückführschleife zwischen der Shift-Matrix SHM3 und dem Register MR2 versorgt wird.

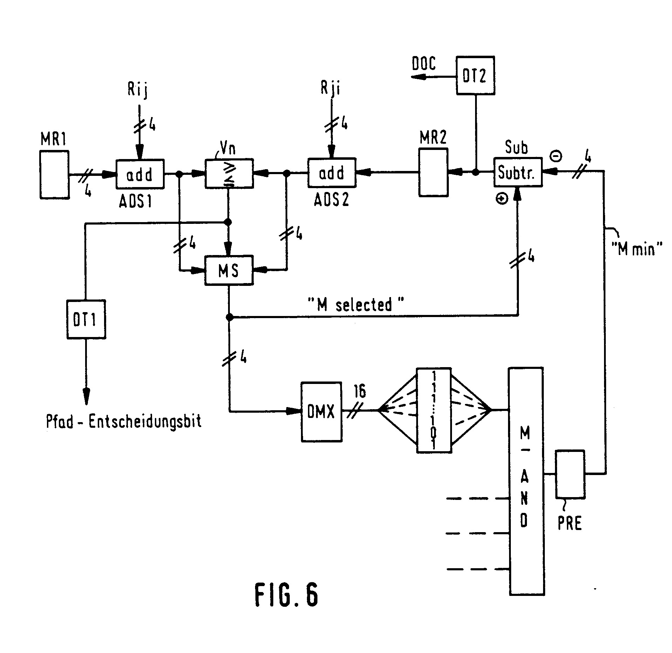

Eine andere Ausgestaltung der ACS-S-Netzwerke zeigt Fig. 6. Dort ist ein solches Netzwerk halbarithmetisch aufgebaut; d.h. die Operation "Addieren" und "Vergleichen" werden mittels arithmetischer Addierwerke und Vergleichsstufen ausgeführt. Erst die Verknüpfung über die Multi-AND-Stufe M-AND erfolgt im logischen Operationsbereich. Bei diesem Aufbau ist die Informationsbearbeitung nicht so schnell wie beim Ausführungsbeispiel gemäß Fig. 5, jedoch können leichter beschaffbare Standardbausteine verwendet werden. Die entgegengesetzten Zweigmetriken Rij und Rji werden jeweils einer Additionsstufe ADS1 und ADS2 zugeführt. Die 4-Bit-breiten Ausgänge dieser Additionsstufen sind mit den beiden Eingängen einer Vergleichsstufe Vn verbunden wie auch jeweils mit den Eingängen eines Metrikselektors MS. Die Vergleichsstufe Vn stellt fest, welche der beiden entgegengesetzten Zweigmetriken jeweils größer ist oder ob Gleichheit besteht. Ihr Ausgang steuert den Metrikselektor MS. Der Ausgang des Metrikselektors MS ist über einen Demultiplexer DMX an den Eingang der Multi-AND-Stufe M-AND geführt. Der Multiplexer wandelt die arithmetische Operation in eine logische Operation um; d.h. er stellt ein 16-Bit-breites Wort zur Verfügung, das die Metrik als Bitposition auf einer der 16 Leitungen darstellt. Die 16 Ausgänge des Demultiplexers DMX sind wie die Ausgänge aller ACS-S-Netzwerke auf die Multi-AND-Stufe M-AND geführt. Über den Prioritätsenkoder PRE am Ausgang der M-AND-Stufe ist die Minimalmetrik Mmin verfügbar, die in der Subtrahierstufe Sub von der ausgewählten Pfadmetrik "M selected" subtrahiert wird. Die Subtrahierstufe Sub speist wie beim Ausführungsbeispiel in Fig. 5 das Metrikregister MR2 und den Minimalmetrikdetektor DT2.

Im folgenden wird auf die Speicherverwaltung selbst eingegangen. Die Technik des Trellis- oder auch "Path-Memory"-Managements ist bei den Ausführungsformen gemäß dem Stand der Technik nicht zufriedenstellend gelöst. Das bezieht sich insbesondere auf wachsende Konstraint-Längen (größer als 3), bei denen der Signalfluß-Aufwand des Informationsverkehrs zwischen den Speicherzellen sehr schnell unüberschaubare Ausmaße annimmt.

Mit der strukturellen Festlegung der Path-Memory wird auch weitgehend die Struktur des gesamten Viterbi-Dekoder-Konzepts fixiert. Das ist auch der Grund, weshalb hierauf zuerst eingegangen werden soll. Aus der Path-Memory-Struktur leiten sich zahlreiche weitere Prozesse wie beispielsweise die Adressierung und die Datenbeschickung ab, und so auch jene Prozedur, die nachfolgend unter der Bezeichnung "Musterprozeß-Verfahren" erscheint und beider es sich im wesentlichen um ein geschwindigkeitsopportunes Adressierungsverfahren handelt.

Die Viterbi-Dekodierung ist, wie bereits angedeutet, vornehmlich ein signalflußintensives Verfahren. Speicherplatz an sich ist weniger sein Problem. Der Grund hierfür liegt schwerpunktmäßig in der Tatsache, daß eine verzögerte Dekodierung mit verspäteter Entscheidung bei der Ausgabe der Quellinformation erforderlich ist. Hinzu kommt der baumartige Charakter des 'Trellis-Diagramms', das mit wachsender Zeilenzahl im Enkoder eine rapide zunehmende Zustandsvielfalt aufweist. Wie aufwendig die Realisation der Path-Memory wird, hängt hauptsächlich davon ab, welcher Information dort abgespeichert werden soll. Grundsätzlich existieren zwei Arten von Path-Memory: In der ersten werden Zweigentscheidungen abgespeichert, d.h. es wird lediglich festgehalten, ob ein neuer Zustand aus einem solchen alten entstanden ist, der - unser Beispiel K = 5 genommen . größer als "8" oder gleich war, oder, ob er aus einem solchen entstanden ist ohne Belegung des MSB ("most significant bit"), also kleiner als "8". Es leuchtet unmittelbar ein, daß bei einem derartigen Verfahren die Information über den tatsächlichen Zustand verloren gegangen ist und nur durch den Umweg einer "Rückverfolgung", eines "Traceback" bis an den aktuellen Anfang, wiedergewonnen werden kann. Sieht man einmal von eventuellen Laufzeitverlusten bei diesem Verfahren ab, so bleibt noch ein relativ kompliziertes Signalflußsystem zwischen den Speicherzellen, das in seinem Umfang mit wachsender Konstraint-length ebenfalls anwächst. Die Folgen sind nicht nur ein unverhältnismäßig hoher Hardware-Aufwand, sondern ebenso eine stark ansteigende Signalunsicherheit, verbunden mit einer schweren Überprüfbarkeit des Systems. Wegen dieser und anderer Imponderabilien wurde schon recht früh von einer derartigen Systemrealisierung abgesehen.

Die zweite Art von Path-Memory, die beim Dekoder nach der Erfindung eingesetzt wird, kennzeichnet sich durch die Abspeicherung von Quellbitsequenzen und erscheint deswegen recht reizvoll, weil in dieser Form am Ausgang die dekodierte Information dirket zur Verfügung steht und nur noch nach Maßgabe der minimalen Metrik dort abgeholt zu werden braucht. Ein jedoch nicht zu unterschätzender Nachteil war aber bei diesem Verfahren bisher seine Realzeitfeindlichkeit. Sie liegt einfach darin begründet, daß ein neuer Schieberegisterzustand nur in seltensten Fällen gleich ist mit seinem Vorgänger. Betrachtet man das Trellis-Diagramm (Fig. 2), dann fällt auf, daß das sogar nur in höchstens zwei Fällen vorkommen kann, nämlich dann, wenn eine "0" aus einer "0" oder eine "15" aus einer "15" entstanden ist, also bei der Minimal- und der Maximalbelegung des Schieberegisters. Ordnet man daher dem aktuell hineingeschobenen "Kopfbit" einen festen Zustand bei, so erhält man für das hier verfolgte Konzept von K = 5 eine Vielfalt von 16 verschiedenen Speicherzeilen, in denen außer den genannten Kopfbits die Information aus der Vergangenheit dieses Zustandes stehen. Da aber jeder neue Zustand immer aus einer ganz anderen "Informationskette" (einem Trellis-Pfad) hervorgeht, müßte jede Zeile nicht nur mit einem neuen Kopfbit aktualisiert, sondern auch mit einer anderen völlig ausgetauscht werden, damit am Ende die Zuordnung wieder korrekt eingestellt ist. Da diese Zusammenhänge auch für die Spezifikation sehr wichtig sind, sei wiederum ein Beispiel angegeben:

Im folgenden sei angenommen, daß der Zustand "0" als Vorgänger die "8" hatte, die "8" hingegen aus der "4" entstanden ist. Der Fig. 2 ist dieser Sachverhalt leicht zu entnehmen. Dann müßte folglich die gesamte Informationssequenz der "0" bis auf das Kopfbit durch die Informationssequenz der "8" ersetzt werden. Die Sequenz der "8" ihrerseits hingegen hätte der "4" zu weichen. Das darf aber keinesfalls überschreibend geschehen, weil dann die 8-er Sequenz nicht mehr zum Aufbau der 0-Sequenz zur Verfügung stände usw.. Man sieht, daß der gesamte Speicherplatz doppelt gepuffert zur Verfügung stehen müßte, um während der Prozedur keine Information zu verlieren. Zudem würde man durch die zahlreiche Umspeicherung sehr viel Prozeßzeit verlieren, weshalb dieses Verfahren für schnelle Dekoder ausscheidet. Nun ist aber das Verfahren der Informationsabspeicherung wegen seiner Übersichtlichkeit und dem Fehlen des signaltechnisch aufwendigen "Traceback" äußerst vorteilhaft. Es lag daher nahe, den Vorteil der Informationsabspeicherung (übersichtlichkeit, leichte Zugreifbarkeit) mit dem der Entscheidungsspeicherung (größere Echtzeitfähigkeit) zu verbinden.

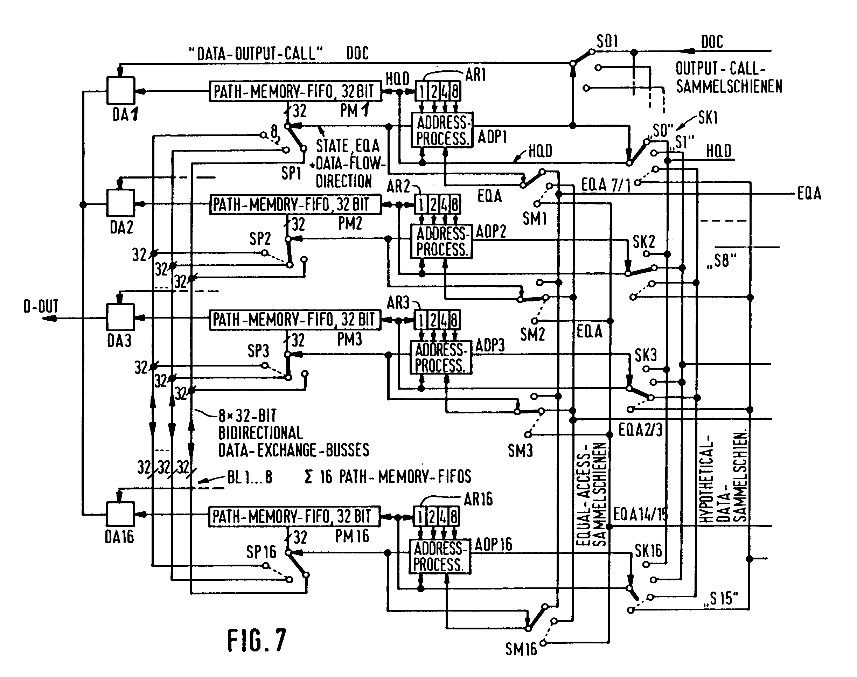

Fig. 7 zeigt das Prinzip der Path-Memory-Ansteuerung. Die nachfolgend verwendete Bezeichnung "Musterprozeß-Verfahren" beruht auf der Tatsache, daß die möglichen, enkoderseitigen Zustände bei diesem Verfahren in jedem Schritt realzeitmäßig nachgebildet werden und der Adressierung der Path-ˎ Memoryzeilen dienen. Das geschieht mit Hilfe der "Musterprozeß-Schieberegister" - Adreßregister AR1 ... AR16 - und der Adreßprozessoren ADP1 ... ADP16, die diverse Multiplexer, hier dargestellt als Vermittlungsschalter SK1 ... SK15, steuern. Diese Multiplexer schalten für verschiedene Signale einen der Adresse des Musterprozesses entsprechenden Datenkanal zu Pufferspeichern PM1 ... PM16, nachfolgend als Path-Memory bezeichnet, durch.

Zunächst sei das Signal HQD (Hypothetische Quelldaten) betrachtet:

Er repräsentiert unmittelbar den Strom der Informationssequenz, die zum einen den Kopf der Path-Memory PM1 ... PM16 speist, zum andren natürlich den Musterprozeß, d.h. die Adressregister AR1 ... AR16, mit aktuellen Daten versorgt. In diesem Zusammenhang sei kurz auf die Grundidee dieses Verfahrens hingewiesen: Oben war von einer ständig notwendigen Umspeicherung der Path-Memory-Zeilen die Rede, wenn der "Kopf" der Zeilen festen Zuständen zugeordnet ist. Hier ist die Kopfadresse grundsätzlich variabel, sie wechselt im Takt der vom Empfang gesteuerten , statistisch abhängigen Musterprozesse, was eine spätere Umspeicherung erspart, da die Daten gleich an den richtigen Platz gelangen ("In-Place-Computation"). Außerdem ist die Path-Memory-Zeile jetzt als FIFO ("first-in-first-out" Speicherung) ausgebildet, so daß die nun übrig bleibende Umspeicherung von je einem Bit mit Hilfe eines einzigen Taktes erfolgen kann. Auf diese Operation ist jetzt das aufwendige "Trace-Back" reduziert worden. Der Begriff des "FIFO" sei hier keineswegs festgelegt. Es kann sich dabei sowohl um einen elastischen Speicher handeln, bei dem die vorn eingegebenen Daten sofort bis zum Ende der Warteschlange "durchfallen", es kann aber auch lediglich ein schnelles, kaskadierbares Schieberegister Anwendung finden, was hier der Fall sein wird, da die elastischen Speicher momentan noch zu lange Durchlaufzeiten besitzen.

Als nächstes sei das Signal DOC (Data-Output-Call) betrachtet:

Jeder der 16 Path-Memory-Zeilen ist ein solches Signal zugeordnet. Seine Zuführung erfolgt ebenfalls über Adreßschalter SD1 ... SD16, die jeweils von einem der Adreßprozessoren ADP1 ... ADP16 gesteuert werden. Von den (ortsfesten) ACSS1 ... ACSS16 Rechenwerken wird nach der Feststellung der minimalen Metrik an der entsprechenden Stelle ein "Alarmsignal" abgegeben, das die Ausgabe eines Quellbits aus dem favorisierten Memoryteil ausgeben soll. Damit dieser Ruf aber ebenfalls an die richtige Stelle gelangt, ist der weg über die "Vermittlungsschalter" SD1 ... SD16 notwendig.

Zusammenfassend läßt sich die Arbeitsweise der Path-Memory dadurch beschreiben, daß Informationssequenzen linear, d.h. nach Maßgabe einer FIFO-Prozedur abgespeichert werden und das "Traceback" lediglich durch einen 1-Bit-Shift realisiert wird. Das ist nur möglich, weil die Adressierung, d.h. die Adressen der Memoryzeilen nicht ortsfest sind, sondern aus $2^{k-1}$ Musterprozessen abgeleitet werden, die vor den Memoryzeilen ablaufen und mit Quellbitdaten aus dem entsprechenden ACSS-Netzwerk gespeist werden. Ferner ist die Ausgabe eines dekodierten Quellbits dadurch charakterisiert, daß sie ebenfalls unter Zwischenschaltung der Musterprozess-Adressierung erfolgt.

Mit dem oben gesagten ist jedoch das "Musterprozess-Verfahren" noch nicht vollständig beschrieben. Die Realisierung der Viterbi-Dekodierung erfordert noch die Berücksichtigung eines Sonderfalles, der im Verlauf der Dekodierung auftreten kann.

Es ist dies der Fall einer Verzweigung im Trellis-Diagramm, wie er indirekt bei der Behandlung des Trellis-Diagrammes beschrieben wurde: Eine der 16 Pfadmetriken ist gegenüber den anderen so niedrig geworden, daß zwei neue Zustände - ungeachtet des Extremwertcharakters der Zweigmetriken - zur gleichen Zeit ihre Entstehung aus einem einzigen, alten Zustand errechnen. Das hat natürlich zur Folge, daß der jeweils gepaart beigeordnete, alte Zwillingszustand (Symmetrielinie in diesem Beispiel bei der "8") samt seinem angehängten Pfad aus vorgeschichtlichen Zuständen verworfen wird. Die Dekodierung entledigt sich also einer ganzen Path-Memory-Zeile, die somit als verfügbar angesehen werden kann. Diese Verfügbarkeit für neue Informationen ist sogar unbedingt notwendig, wenn man bedenkt, daß in jedem Zeitschritt volle 16 neue Zustände durch bearbeitet werden sollen. Errechnen sich also zwei neue Zustände aus einem alten, so müßten eigentlich beide 1.) den des überlebenden, alten Musterprozesses und 2.) den Inhalt des Kopfbits der überlebenden Path-Memory-Zeile überschreiben. Da das nicht möglich ist - es handelt sich hier um einen sogen. "Equal-Access-Vorgang" (hier so definiert und mit "EQA" bezeichnet), muß der gesamte Inhalt des überlebenden Path-Memory-Zweiges vor der Aktualisierung des Kopfbits auf den Inhalt des verworfenen Zweiges überschrieben werden. Das Resultat am Ende dieses Prozesses ist folglich eine neues Paar von Memory-Zeilen, deren Inhalt sich bis auf das Kopfbit gleicht. Letzteres ist zwangsweise verschieden, da die beiden neuen Zustände gerade und ungerade sind.

Die Realisation dieses EQA-Vorganges ist sehr stark dadurch bestimmt, wie oft er pro Zeitschrift, d.h. bei der Ausführung der gesamten Viterbi-Dekodierung notwendig ist.

Es sind grundsätzlich zwei Realisierungen möglich: Die sequentielle und die parallele.

Nach genaueren Untersuchungen stellte sich heraus, daß der EQA-Vorgang durchschnittlich etwa 3 mal je empfangenem Dibit eintritt, wobei allerdings bei Einschwingvorgängen (Start des Dekoders, Sprünge in der Störbeaufschlagung) "Overheads" von bis zu vollen acht EQA's je Zeitschritt auftraten. Die sequentielle Lösung mußte somit verworfen werden, da sie im Extremfall acht Paarbildungen zeitlich nacheinander hätte vornehmen müssen, wobei nur eine Zeit von 100 nS zugrunde gelegt werden kann (für einen ganzen Zeitschritt).

Die parallele Lösung ist ebenfalls in Fig. 7 angeboten:

Bei 16 stets neu erzeugten Zuständen ist eine Bildung von maximal 8 Paaren möglich. Der Befehl zur Paarbildung wird durch das EQA-Signal repräsentiert. Dem Musterprozeß-Verfahren gemäß wird auch dieses Signal über Multiplex-Schalter SM1 ... SM16 adressiert, die in diesem Fall jedoch nur acht Stellungen benötigen. Hernach wird es im jeweiligen Adreßprozessor ausgewertet. Das Ergebnis dieser Auswertung ist wiederum die Positionierung von anderen Vermittlungsschaltern SP1 ... SP16. Sie sind jeweils unter den Path-Memory-Zeilen zu sehen. Jedes im FIFO stehende Bit sei parallel zugänglich und mit einem der Vermittlungsschalter SP1 ... SP16 versehen. Dann ist es möglich, jedes Bit der Path-Memory mit jedem paarweise, und zwar entsprechend der EQA-Information, zu verbinden, wobei die Datenflußrichtung bzw. deren bestimmende Signale später behandelt werden sollen.

Es existieren also in dieser Lösung, das sei zusammengefaßt, acht verschiedene Datenbusse BL1 ... BL8, über die je zwei Path-Memory-Zeilen ihre gesamten Daten austauschen können. Die Wahl dieser Busse bestimmt wiederum der dazugehörige Musterprozeß und die EQA-Information sowie ein Signal zur Datenflußrichtungs-Bestimmung. Es wird später zu sehen sein, daß letzteres Signal aus den hypothetischen Quelldaten ableitbar ist.

Zusammenfassend läßt sich die Arbeitsweise der Path-Memory dadurch charakterisieren, daß eine Verzweigung im Trellis-Vorgang mit einer Paarbildung zweier Informationssequenzen einhergeht. Diese Paarbildung ist dadurch charakterisiert, daß sämtliche Bits einer nicht überlebenden Sequenz durch die der dazugehörigen, überlegenden überschrieben werden. Ein solcher Vorgang wird mit EQA bezeichnet werden, was "Equal-Access" (= gleicher Zugriff) bedeutet. Für High-Speed-Anwendungen sei die Realisation dadurch charakterisiert, daß der EQA auf $2^{K-2}$ parallel adressierbaren Datenbussen BL1 ... BL8 erfolgt, wobei K die Konstraint-Length des Enkoders ist. Die Adressierung der Datenbusse BL1 ... BL8 erfolgt ebenfalls mit Hilfe der Musterprozesse.

Die Signalflußintensität der Path-Memory tritt an dieser Stelle besonders zutage, was nicht zuletzt durch das Vorhandensein von acht verschiedenen Datenaustausch-Bussen auf der gesamten Breite bzw. Länge der Memory verdeutlicht wird. Ist die Realisierung auch logisch recht einfach und übersichtlich strukturiert, so ist sie dennoch räumlich aufwendig. Die Anzahl der notwendigen, bidirektionalen Bustreiber übersteigt bei weitem die Anzahl der Memory (FIFO-) Hardware, weshalb eine Integration des gesamten Path-Memory-Teils vorteilhaft ist. Dieser Teil würde als Chip eine ähnliche Einheit bilden wie die seit langem gängigen RAM's oder EPROM's, zumal die Technik der Viterbi-Dekoder voraussichtlich breitere Anwendung finden wird. Es soll daher an dieser Stelle ausdrücklich auf die Möglichkeit eine VLSI-Integration hingewiesen werden.

Einen anderen Aspekt bildet die bereits kurz angedeutete serielle Lösung des EQA.

Für Nicht-High-Speed-Anwendungen (kleiner als 5 MBit/sec.) bietet sich die serielle Abarbeitung der EQA-Vorgänge an, da sie räumlich wesentlich weniger aufwendig ist. So entfallen die bidirektionalen Bustreiber völlig, da es Schieberegister mit bidirektionalen Datenkanälen bereits gibt und die Bus-Vermittlung nicht mehr notwendig ist. An ihre Stelle tritt nun eine Prioritätszählung, die lediglich entscheidet, welches Speicherpaar als nächstes Daten austauschen soll.

Eine alternative Realisation der Path-Memory ist dadurch charakterisiert, daß der EQA-Datenaustausch auf einem Datenbus für jedes Speicherzeilenpaar zeitlich nacheinander erfolgt und die hierfür erforderliche zeitliche Priorisierung ebenfalls aus den Musterprozessen abgeleitet wird.

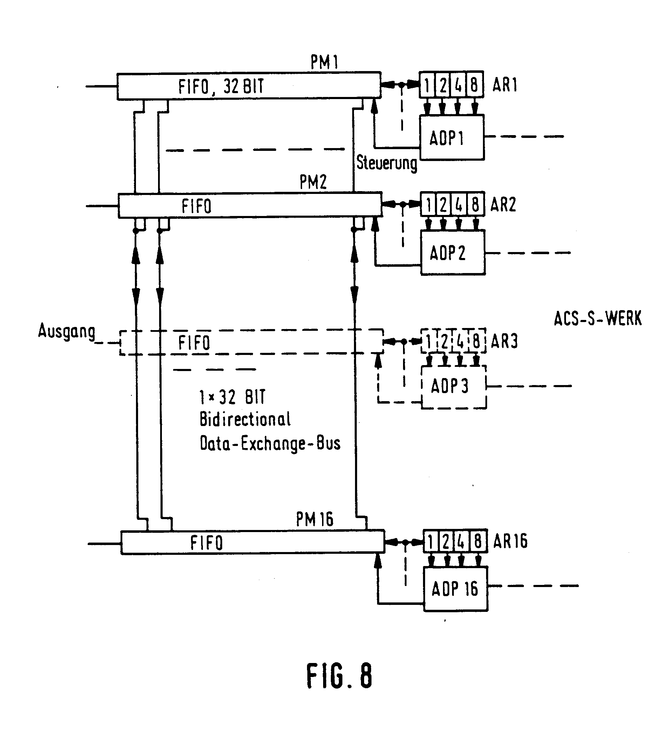

Fig. 8 zeigt dieses Prinzip, das ebenfalls durch eine VLSI-Integration insbesondere durch seinen dann vorhandenen Geschwindigkeitsgewinn erhebliche Vorteile besitzt. Beide Versionen der Path-Memory sind voll kaskadierbar. Ihre Ausgänge können mit den Eingängen weiterer Einheiten verbunden werden, während die Steuersignale wie EQA etc. parallel mitgeführt werden. Das unterstreicht die Flexibilität dieses Systems z.B. im Hinblick auf die Verwendung sog. "punktierter Codes" bei denen ein Vielfaches der Path-Memory-Länge zugeschaltet werden muß.

Die Schnittstelle zwischen den bereits beschriebenen Baugruppen "ACS-S-Werk" und "Path-Memory" bereitet unter rein technischen Aspekt keinerlei Komplikationen. Sie stellt aber gerade deswegen als logische Einheit eine Besonderheit dar. Aus ihr werden nicht nur die hypothetischen Quelldaten, sondern auch die wichtigen Informationen für den "Equal-Access" abgeleitet. Insbesondere die Information über die Datenflußrichtung in einem solchen Falle - welcher Speicher überschreibt welchen - wurde noch garnicht behandelt.

Das Data-Output-Call Bit erfährt in dieser Schnittstellenstufe keinerlei Modifikationen. Es gelangt unter galvanischer Kopplung direkt auf die Multiplexschalter SK1 ... SK16 des jeweiligen Adreßprozessors ADP1 ... ADP16.

Das "Pfadentscheidungsbit" als Ausgangssignal eines ACSS-Werkes ist entsprechend der 16 ACS-S-Einheiten 16 mal vorhanden und gibt, seinem logischen Zustand entsprechend, an, ob der aktuelle neue Zustand aus einem solchen alten entstanden ist, der kleiner als 8 war, oder aus einem mit der Quantität "größer oder gleich 8". Dieses Bit gibt also die Lage des alten Zustandes ober- oder unterhalb der Symmetrielinie gemäß Fig. 2 an.

Dieses Ausgangssignal Output stimmt aber keineswegs mit dem überein, was am Eingang der Path-Memory gefordert ist:

Eine Aussage über den neuen Zustand, nämlich, ob er gerade oder ungerade ist, oder anders ausgedrückt: ob als hypothetisches, neues Quelldatenbit eine "0" oder "1" zugrunde zu legen ist!

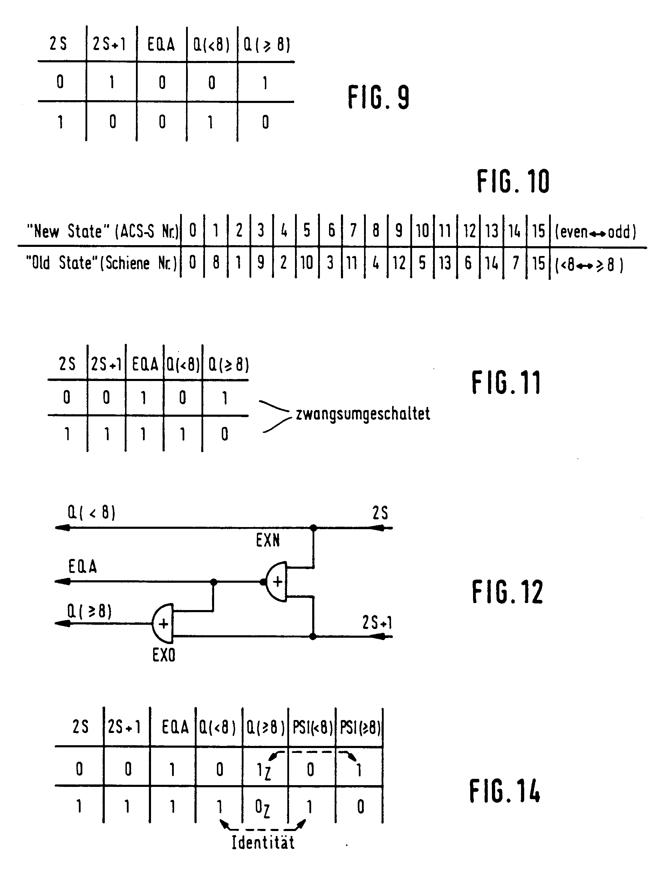

Wie sich zeigt, löst sich dieses Problem aber sehr leicht, wenn man gewisse Randbegingungen beachtet. Es sei angenommen, eine logische "1" stelle eine Vergangenheit größer oder gleich 8 dar, eine "0" entsprechend das Gegenteil. Dann läßt sich für den Fall, daß kein EQA auftritt, die Wertetafel gemäß Fig. 9, die die Umkodierung des Entscheidungssignals zeigt, aufstellen.

Darin bedeutet "2S" einen neu entstehenden, geraden Zustand ("even") und "2S + 1" einen ungeraden Zustand ("odd"). Entsprechend seien "Q( 8)" das hypothetische Quellbit, das in die alte Adresse "kleiner als 8" gelangen soll. "Q(≧8)" hingegen das Quellbit mit dem Ziel "größer als 8 oder gleich 8". Dann ist die Wahrheitstafel folgendermaßen zu verstehen:

Das ACS-Werk "2S", das zu einem geraden Zustand gehört, gibt seine Entscheidung aus, die bedeutet: "Vergangenheit kleiner als 8" (logische "0"). Es müßte somit in die Adresse "Q(<8) eine "0" schreiben.

Das ist in der Tafel gemäß Fig. 9 vermerkt.

Da weiterhin vorausgesetzt wurde, daß kein EQA vorliegen soll, gibt entsprechend das ACS-S-Werk "2S + 1" eine inverse Information aus: "1" mit "Vergangenheit größer oder gleich 8! "In die Adresse" Q(≥8) wird - so ist es gefordert - eine "1" geschrieben. Zusammengefaßt: Ungerade Zustände geben stets eine logische "1" aus, gerade eine"0". So ist es gefordert, denn beim Hineinschieben einer "1" in das Enkoder-Schieberegister ergibt sich natürlich ein ungerader Zustand. Umgekehrtes gilt für die "0".

Bei den hier vorhandenen ACS-S-Werken, die ortsfesten Zuständen zugeordnet sind, ist jedoch Vorsicht geboten. Sie geben logische Zustände mit anderer Bedeutung als "gerade" und "ungerade" aus. Beim obigen Beispiel stimmte das Datenbit "0" zufällig mit dem Output-Bit "2S" bzw. "2S + 1" überein.

In der zweiten Zeile der Tafel ist der umgekehrte Fall vermerkt: Jetzt gibt das "gerade" ACS-S-Werk "2S" eine "1" aus mit der Bedeutung: "Vergangenheit größer als 8". Die Tafel zeigt das geforderte Quellbit in der Spalte "Q(≥8)": eine logische "0" (= gerader, neuer Zustand). Umgekehrt ist es beim ACS-S-Werk "2S + 1": Es gibt eine "0" aus mit dem Verlangen, in die Adresse "kleiner als 8" eine "1" zu schreiben, seiner Parität gemäß. Aus der Tafel und dem oben gesagten ergibt sich die einfache Konsequenz:

Solange kein "Equal-Access" auftritt genügt es, geraden Zuständen zugeordnete ACS-S-Werke mit Adressen "kleiner 8" zu verbinden und ungeraden Zuständen zugeordnete Rechenwerke mit Adressen "größer oder gleich 8". Daß im zweiten, oben geschilderten Fall das Werk "2S" eine "1" ausgab, und entsprechend das Werk "2S + 1" eine "0", stört keinesfalls, denn wegen der Alternativität der biden Outputs gaben die Rechenwerke füreinander stellvertretend den richtigen Zustand aus.

Die Umkodierung besteht hier also lediglich in einer Bedeutungswandlung unter Berücksichtigung der Randbedingung, daß kein EQA zu unterstellen ist. Fig. 10 zeigt das daraus folgende Verbindungsschema zwischen den ACSS-Netzwerken und den Adreßprozessoren.

"Equal-Access" heißt in Bezug auf den Output des ACS-S-Werkes, daß sowohl eine gerade als auch eine ungerade Einheit die gleiche Vergangenheit beanspruchen, d.h. logisch gleiche Zustände ausgeben.

Geben z.B. sowohl "2S" als auc "2S + 1" eine "0" aus, so bedeutet das, daß beide zur gleichen Zeit eine Ausgabe an die Adresse "kleiner 8" tätigen wollen, und zwar wiederum ihrer Parität gemäß, also "2S" eine"0" und "2S + 1" eine "1". Fig. 11 zeigt die beiden Sonderfälle für einen EQA-Zustand im System. Dabei ist zunächst die Tabelle gemäß Fig. 10 als Verbindungsliste weiterhin zugrunde zu legen. Auffallend ist, daß das EQA-Signal jetzt "1" ist und damit einen solchen Zustand definiert. In der ersten Zeile ist das obengenannte Beispiel aufgezeigt: Zwei Rechenwerke geben den gleichen Zustand aus, wobei die Ausgabe von "2S" (eine "0") wiederum passend ist. Sie gelangt auf direktem Weg zur Adresse "kleiner als 8". Die Ausgabe von "2S + 1" hingegen ist hier falsch: Ihre Bedeutung muß, den Anforderungen entsprechend, gewandelt werden. Hatte sich noch beim Verlassen des ACS-S-Werkes die Bedeutung eines "Pointers", so muß sie jetzt auf Grund der Bedeutung eines "Datenbits" zwangsumgeschaltet werden, was in der Wahrheitstafel vermerkt ist. Jetzt stimmt die Ausgabe in diesem Fall wieder:

An die Adresse "kleiner als 8" gelangt ein Datum "0" aus dem ACS-S-Werk "2S", und auch die Ausgabe der Einheit "2S + 1" gelangt an ihren richtigen Bestimmungsort: Q(≥8) ist nun "1".

Nun soll der zweite EQA-Sonderfall betrachtet werden: Beide Rechenwerke geben eine "1" aus mit der Intention, in die Adressen "größer als 8" zu schreiben, wiederum ihrer Parität gemäß.

Es sei hierbei angenommen, daß wiederum das nach "Q(<8)" gelangende Bit unverändert bleibt, das nach "Q(≥8)" gelangende hingegen zwangsumgeschaltet wird. Dann stimmt die so eingeschriebene Dateninformation wiederum exakt: In die Adresse "Q(<8)" gelangt eine "1" (Bedeutung: "Aus dem "2S + 1"-Werk stammend"), wobei natürlich, wie beim ersten Fall auch, zu bedenken ist, daß je eine Path-Memory-Informationszeile dupliziert wird: Das Bit "Q(≥8)" wird wiederum gegensätzlich sein, hier also eine "0".

Die oben beschriebenen Operationen stellen also sicher, daß sowohl die Musterprozesse als auch die Speichertitos stets die korrekten Quellbit-Informationen erhalten, wobei eine Bedeutungswandlung der aus den ACS-S-Einheiten stammenden Information vorgenommen wird. Die "Verzweigung" im Trellis-Diagramm wird hierbei durch eine Zwangsumschaltung der betreffenden Bits simuliert. Somit entstehen auch bei einem "Equal-Access" stets zwei völlig neue, verschiedene Musterprozeß-Zustände, nämlich ein gerader und ein ungerader sowie zwei identische Path-Memory-Zeilen mit verschiedenen Kopfbits. Diese logisch etwas komplizierte Prozedur wird mit Hilfe von acht sehr einfachen Schaltungskonfigurationen realisiert, die in Fig. 12 dargestellt sind.

Die EX-NOR-Verknüpfung EXN erzeugt das EQA-Signal bei gleichen Ausgabezuständen, die Zwangsumschaltung wird durch das EX-OR-Element EXO bewirkt. Es werden, wie beschrieben, nur die "ungradzahligen" Kanäle umgeschaltet. Der laufzeitarme Charakter der Schaltung leuchtet ein.

Zusammenfassend läßt sich das Interface der ACS-Werke zur Versorgung des Path-Memory-Adreßprozessors mit Daten dadurch charakterisieren, daß Daten mit Pfad-Entscheidungscharakter in solche mit Informationscharakter im Sinne der hypothetischen Quellinformation umgewandelt werden.

Ferner ist es dadurch charakterisiert, daß dies durch Umkodierung des Informationsgehaltes "größer oder gleich $2^{K-2}$" und "kleiner $2^{K-2}$" in den Informationsgehalt "ungerade" und "gerade" erfolgt, die Zuordnung der Bedeutungen sowie das Vorzeichen der Logik jedoch nicht festgelegt werden sollen.

K sei hierbei die Konstraint Length. Für den Falle eines "Equal-Access" (Verzweigung im Trellis-Diagramm) ist es dadurch charakterisiert, daß das jeweilige Bit einer Parität zwangsumgeschaltet wird, um dann den Informationsgehalt "gerade" und "ungerade" parallel zur Verfügung zu stellen. Schließlich ist das Interface noch dadurch charakterisiert, daß es genau $2^{K-2}$- mal ein "Equal-Access-Signal" gemäß voriger Beschreibung zur Verfügung stellt, das die Gleichheit der Ausgangssignale zweier ACS-S-Werke mit gerader und ungerader Statuszuordnung anzeigt.

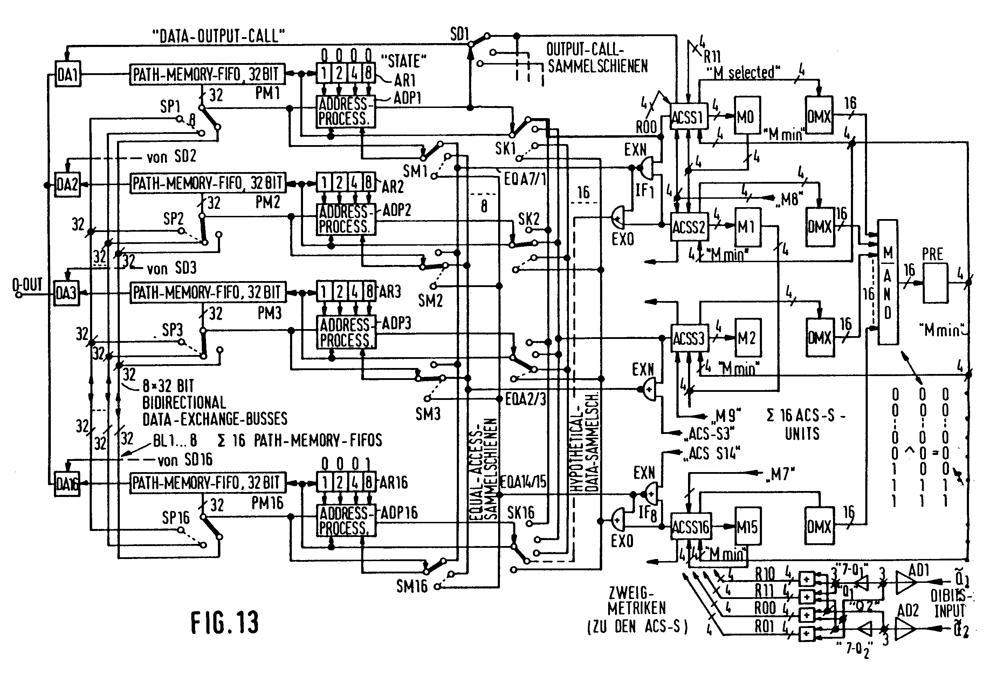

Eine Übersicht über die Gesamtschaltung zeigt Fig. 13. Bezogen sich die vorangegangenen Ausführungen hauptsächlich auf Verfahrensdetails, so soll jetzt der Augenmerk auf die Gesamt-Signalverarbeitung gerichtet sein. Auf die bereits behandelten Baugruppen bzw. Verfahrensmerkmale wird nicht nochmals eingegangen.

Eine Ausnahme bildet das Datenflußrichtungssignal für den "Equal-Access", das letztendlich nur im Zusammenhang mit dem Gesamtsystem erläuterbar ist, und das deshalb erst jetzt behandelt wird.

In der rechten Hälfte von Fig. 13 sind die Eingangssektion und die ACS-S-Werke zu sehen, die in ihren Einzelheiten bereits beschrieben wurden. Die Verbindung zwischen beiden Blöcken wird durch die 4x4 Bit-Leitungen hergestellt, die rechts unten zu sehen sind und mit "$R_{00}$ ... $R_{11}$" bezeichnet sind. Das ist der Datenstrom der Zweigmetriken, der mit dem Strom der empfangenen Dibits synchron läuft. Es ist zu vermerken, daß, dem Trellisgesetz gemäß der Kodierung entsprechend, stets nur zwei der vier-Bit-Bündel mit einem ACS-S-Werk verbunden sind, nämlich die besagten gegensätzlichen Zweigmetriken. Es finden jedoch alle, wie bereits erörtert, eine gleichverteilte Anbindung innerhalb des gesamten ACSS-Komplexes. Sie ist - der Übersicht halber - hier nicht vollständig gezeichnet.

Nachdem die beschriebenen Metrikrechnungen abgelaufen sind - was asynchron, d.h. mit maximal möglicher Geschwindigkeit geschieht - wird noch nicht in die Metrik - Aktualisier-Register M0 ... M15 die in Verbindung mit den Figuren 5 und 6 behandelt wurden zurückgeschrieben, weil die Ausgangs-Information des ACS-S-Werke noch anstehen soll. Erst, wenn sie innerhalb der ACSS-Werke zwischengespeichert worden ist, wird das Metrikregister aktualisiert. Nach der ebenfalls oben beschriebenen Interface-Modifikation gelangen die hypothetischen Quellbitdaten, das EQA-Signal und das Data-Output-Call-Signal auf die Sammelschienen und von dort zu den Multiplexern (Vermittlungsschaltern), die von den Musterprozeß-Zuständen angesteuert werden. Solange noch die alten Zustände anstehen, läuft die EQA-Prozedur und das Aktualisieren der Path-Memory ab. Erst dann wechseln auch die Musterprozesse ihre Zustände und damit die Multiplex-Schalter ihre Stellung gemäß der Metrikrechnung. Nun erfolgt der "Data-Output-Call" und damit die Ausgabe eines dekodierten Informationsbits durch die Datenausgabeeinheiten DA1 ... DA16. Um den Vorgang in der Geschwindigkeit zu erhöhen ist es vorteilhaft, die Rechenergebnisse voneinander entkoppelter Prozesse mit Hilfe von Zwischenspeichern aufzutakten, so daß die Dekodierung zwar um wenige Schritte verzögert, dafür aber schneller erfolgt. Bei diesen entkoppelten Prozessen handelt es sich um:

1) Sample-Hold-Convert bei den A/D-Wandlern AD1, AD2 sowie die Zweigmetrik-Berechnung
2) ADD-Compare-Select-Subtract in den ACSS-Werken
3) Aktualisieren der Metrikregister
4) EQA-Prozedur
5) Aktualisieren von Musterprozeß und Path-Memory sowie Datenausgabe.

Einige dieser Prozesse lassen sich parallelisieren, so daß nicht notwendigerweise fünf Taktschritte notwendig sind. Es soll nun auf die Information für die Datenflußrichtung eingegangen werden, die vorhanden sein muß, wenn ein EQA-Fall auftritt und eine Path-Memory-Zeile überschrieben werden soll.

Im Schaltbild fällt vor allen Dingen auf, daß hierfür kein zusätzliches Signal vorgesehen ist, das ja ebenfalls über separate Multiplexer samt Sammelschienen geführt werden müßte.

In der Tat steckt diese Information bereits in der Kombination aus hypothetischen Quelldaten und EQA-Signal, wobei man bedenken sollte, daß die hypothetische Quelldaten-Information ursprünglich die Bedeutung einer Pfadentscheidung besaß, wie ausführlich erläutert wurde.

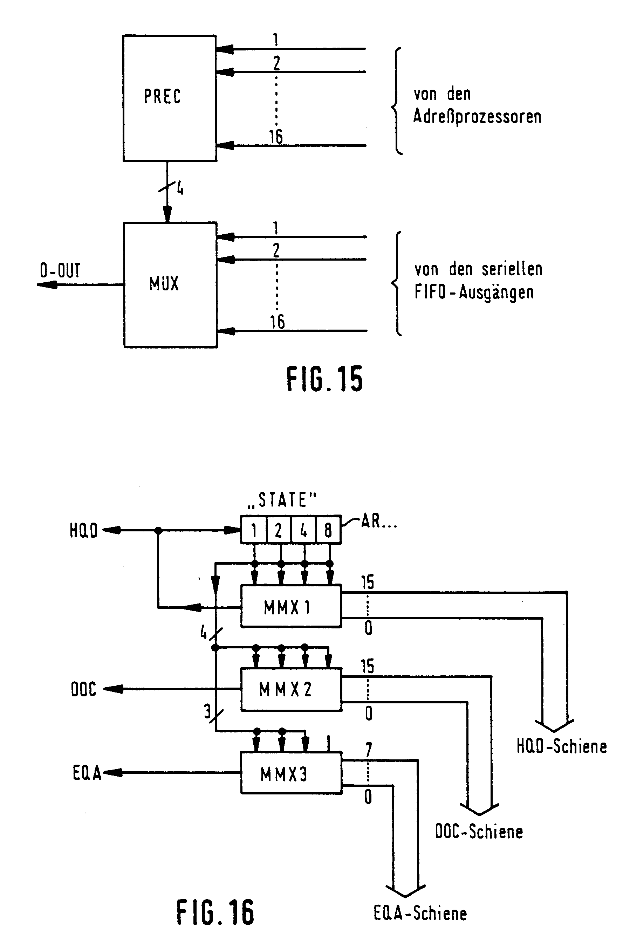

Es kann also eine Menge Schaltungsaufwand erspart werden, wenn man einige einfache Zusammenänge beachtet, wie sie in der folgenden Wahrheitstafel gemäß Fig. 14 niedergelegt sind. Fig. 14 gibt das Datenfluß-Richtungssignal bei EQA (Verzweigung im Trellis-Diagramm) nieder.

In Fig. 13 ist nur der Fall aufgezeigt, daß ein EQA-Zustand auftritt. Nur dann wird ein Datenaustausch zwischen den Memoryzeilen notwendig. Es gibt dann, das sei kurz wiederholt, zwei verschiedene Konfigurationen:

1) Beide ACSS-Ausgangssignale sind "0" (Pointer auf Adresse "kleiner 8")

2) Beide ACSS-Ausgangssignale sind "1" (Pointer auf Adresse größer oder gleich 8")

Beide Fälle sind in der Tabelle gemäß Fig. 14 zu sehen. Zunächst sei Fall 1) betrachtet: Da ursprünglich beide Pointer auf eine Adresse "kleiner 8" zeigen, ist der dazugehörige Musterprozeß und die Path-Memoryzeile offenbar favorisiert worden. Das bedeutet, daß diese Daten auf keinen Fall überschrieben werden, sondern vielmehr diejenigen Daten, die zur Adresse "größer oder gleich 8" gehören, überschreiben sollen. Definiert man daher eine logische "1" als einen "Überschreibe-Befehl" am Ort der dazugehörigen Adresse, dann ist die Information richtig angekommen, wie die Tabelle gemäß Fig. 14 zeigt: Das zwangsumgeschaltete Bit bei "Q($\geq$8)" dient gleichzeitig als Parallel-Shift-in-Befehl.

Nun sei Fall 2) betrachtet. Beide Pointer verlangen eine Adresse "größer oder gleich 8". Jetzt müssen, umgekehrt. die Daten der Memoryzeile mit der Adresse "kleiner 8" überschrieben werden. Wie man sieht, kann als Befehl hierzu wiederum das hypothetische Quelldatenbit "Q( 8)" dienen, das diesmal nicht das zwangsumgeschaltete, sondern das "direkte" Bit ist.

Der Grund für diese Identität ist folgender: Die ACSS-Ausgangssignale stellen ursprüchlich Pointer dar. Sie geben daher konkret an, welche Adresse favorisiert werden soll. Die durch den "Equal-Access" entstehende Zweideutigkeit wird durch die Zwangsumchaltung beseitigt. Somit kann ein sowohl logisches wie auch örtliches Kriterium für die Datenflußrichtung abgeleitet werden.

Für das Gesamtsystem gilt allgemein, daß die Steuerung des parallelen Datenaustausches in der Path-Memory bei "Equal-Access" vom ACSS-Werk her über das ACSS-Adreßprozessor-Interface von der hypothetische Quelldaten-Information selbst vorgenommen wird, die auch als Datenflußricht-Information verwendet wird.

Die Datenausgabeeinheiten DA1 ... DA16 lassen sich sehr einfach in einer Baugruppe zusammenfassen, vgl. Fig. 15, und zwar folgendermaßen: Ein Prioritätenkoder PRED, der wie zuvor aus 2 integrierten Schaltkreisen 74F148 aufgebaut sein kann, erhält die 16 DOC (Data-Output-Call) Signale der Adreßprozessoren hinter den entsprechenden Vermittlungsschaltern zugeführt. Der Prioritätsenkoder PREC mit einem 4-Bit-breiten Ausgang ist auf einen Multiplexer MUX geschaltet, der jeweils einen von den 16 seriellen FIFO-Ausgängen mit dem Datenausgang D-OUT des Dekoders verbindet und zwar nach Maßgabe des Ausgangssignals des Prioritätsenkoders PREC.

Fig. 16 zeigt die Adreßprozessoren mit "State-Registern" sowie die zugehörigen Vermittlungsschalter, die jetzt als Multiplexer MMX1 ... MMX3 realisiert sind. Jede Zelle des "State"-Registers ist über eine 4-Bit-Leitung jeweils mit Steuereingängen der drei Multiplexer MMX1 ... MMX3 verbunden, wobei beim Multiplexer MMX3 nur die ersten drei dieser Leitungen angeschlossen sind. Der Multiplexer MMX1 ist zur Durchschaltung der hypothetischen Quelldatenkanäle (HQD-Signale), der Multiplexer MMX2 zur Adressierung der DOC-Schiene, und der Multiplexer MMX3 zur Adressierung der EQA-Schiene vorgesehen.

Die Beschreibung der Viterbi-Dekodierung ist hiermit abgeschlossen. Sie hatte zum Ziel, ein hochgeschwindigkeitsfähiges Verfahren genau zu definieren, wobei die Wahl der Technologie sich nach den jeweiligen Bedürfnissen richtet. Weiterhin wurde darauf hingewiesen, daß eine VLSI-Integration aus rämlichen Gründen - und wegen der Laufzeiten damit auch aus Gründen der Geschwindigkeit - vorteilhaft ist.

Unter diesen Voraussetzungen ist das Verfahren für die Anwendung in sogenannten "intelligenten Transpondern" an Bord von Satelliten anwendbar.

**Patentansprüche**

1. Verfahren zum Dekodieren von nach einem fehlerkorrigierenden Faltungscode aufbereiteten Binärsignalen, wobei durch Binäroperationen Zweigmetriken und hieraus wiederum Pfadmetriken gemäß der Viterbi-Dekodierung für die Empfangswahrscheinlichkeit der enkoderseitig gebildeten Quelldaten-Binärsignale ermittelt werden, unter Anwendung folgender Schritte:

   - die einen Extremwert aufweisende Pfadmetrik wird durch Transformation vom arithmetischen in den logischen Operationsbereich dadurch überführt, daß die Binärinformation dieser Pfadmetrik als Bitposition innerhalb eines $2^n$-zeiligen Bitwortes, mit n = Stellenzahl der Binärzahl, dargestellt wird,

   - die so aufbereitete Information wird mit den übrigen keinen Extremwert aufweisenden Pfadmetriken, welche ebenfalls einer solchen Transformation unterzogen werden über logische Gatter verknüpft und zwar derart, daß die Pfadmetrik mit dem Extremwert von jeder der übrigbleibenden Pfadmetriken subtrahiert wird,

- alle möglichen enkoderseitig auftretenden Binärsignalzustände werden realzeitmäßig, d.h. zeitgleich für jeden Taktschritt, nachgebildet und jeweils zur Adressierung eines hypothetischen Quelldatenkanals herangezogen, welcher von den Daten der Pfadentscheidung gespeist wird,

- aus jedem hypothetischen Quelldatenkanal werden gleichzeitig sowohl die möglichen nachgebildeten enkoderseitigen Binärsignalzustände für die Adressierung als auch jeweils ein Pufferspeicher aktualisiert,

- bei einer Verzweigung im Trellis-Diagramm der Viterbi-Dekodierung werden die Daten der Pufferspeicher, deren zugehörige Trellispfade nicht überleben, durch die Daten jener Pufferspeicher überschrieben, deren zugehörige Trellispfade überleben,

- die Ausgabe der dekodierten Binärsignale aus den jeweiligen Pufferspeichern wird nach Maßgabe der richtigen Adressierung durch die möglichen enkoderseitigen Binärsignalzustände, bzw. deren Aktualisierung, vorgenommen,

- adressiert werden $2^{K-1}$, mit K = Konstraint-Länge des Faltungskodes, verschiedene Ausgabebefehlskanäle, von denen jeweils nur derjenige einen Ausgabebefehl ausführt, der dem Extremwert der Pfadmetrik beigeordnet ist.

2. Viterbi-Dekoder bestehend aus einer Eingangssektion zur Bereitstellung von Zweigmetriken, die eine Halteschaltung mit nachgeschalteter Einheit zur A/D-Wandlung enthält, Netzwerken zur Berechnung einer Pfadmetrik aus den Zweigmetriken sowie Speichern zum Speichern der Pfadmetrik und Datenausgabeeinheiten gekennzeichnet durch:

- zwei Sample- and Hold-Glieder (SH1, SH2), denen jeweils ein AD-Wandler (AD1, AD2) nachgeschaltet ist zur Quantisierung jeden Bitpaares am Eingang des Dekoders, je einen Multiplexer (MX1, MX2) zur kreuzweisen Vertauschung der Datenkanäle am Ausgang der beiden AD-Wandler (AD1, AD2), logische Gatter (G1, G2,...G12), denen jeweils ein Steuersignal (C1, C2) und ein Ausgangssignal der Multiplexer (MX1, MX2) zugeführt sind, wobei die logischen Gatter viermal pro Bitwortbreite vorhanden sind und für jede Bitwortbreite je zweimal mit nicht invertierenden Ausgängen und zweimal mit invertierenden Ausgängen ausgebildet sind, und vier Volladdierer (ADD1,...ADD4), die derart mit den Ausgängen der logischen Gatter (G1, G2,...G12) verknüpft sind, daß an ihren Ausgängen die Zweigmetriken gemäß der Viterbi-Dekodierung verfügbar sind,

- Ausbildung der Netzwerke (ACSS1,...ACSS16) zum Berechnen der Pfadmetriken und Ausgabe eines Pfadentscheidungsbits sowie zur Erzeugung eines Ausgabebefehls (DOC) für dekodierte Daten durch jeweils eine Vergleichsstufe (Vn; AND16) für entgegengesetzte Zweigmetriken, Pfadentscheidungsbit-Detektoren (DT1), welche an die Ausgänge der Vergleichsstufen (Vn; AND16) angeschlossen sind, Rückführungsschleifen jeweils von den Ausgängen der Vergleichsstufen (Vn; AND16) auf Subtrahierer (Sub; SHM3) zur Verknüpfung mit einer aktuellen Zweigmetrik, an die Rückführungsschleifen angeschlossene Minimalmetrikdetektoren (DT2) zur Erzeugung der Ausgabebefehle (DOC),

- eine Multi-AND-Verknüpfungsstufe (M-AND), welcher die favorisierten Metriken aller vorgenannten Netzwerke zugeführt sind,

einen Prioritätsenkoder (PRE) am Ausgang der Multi-AND-Verknüpfungsstufe (M-AND) sowie Verbindungswege vom Ausgang des Prioritätsenkoders (PRE) zu den Subtrahierern - (Sub; SHM3) der Netzwerke (ACSS1,...ACSS16),

- Adreßprozessoren (ADP1,... ADP16) mit beigeordneten Adressregistern (AR1,...AR16) zur Betätigung von Vermittlungsschaltern (SK1,...SK15) im jeweiligen hypothetischen Quelldatenkanal zwischen den Netzwerken (ACSS1,...ACSS16) zum Vergleich der Zweigmetriken und den als FIFO-Speichern oder Schieberegistern ausgebildeten Pufferspeichern (PN1,...PM16) für die Pfadmetrikinformationen,

- bidirektionale Datentausch-Busse (BL1,...BL8) zum jeweiligen paarweise parallelen Verbinden jener Pufferspeicher (PM1,...PM16), die am Überschreiben bei einer Trellis-Verzweigung beteiligt sind, wobei die Datentausch-Busse (BL1,...BL8) über von Adreßprozessoren (ADP1,...ADP16) gesteuerte Vermittlungsschalter (SP1,...SP16) schaltbar sind,

- Interface-Schaltungen(IF1,...IF8) zwischen den Ausgängen von jeweils zwei Netzwerken (ACSS1,...ACSS16) und den Adreßprozessoren (ADP1,...ADP16) zur Umkodierung der von den Detektoren (DT1) gelieferten Pfadentscheidungsbits in für jeden Taktschritt zeitgleich auftretende hypothetische binäre Quelldaten, die den enkoderseitig auftretenden Daten entsprechen, wobei die Umkodierung im Sinne einer größer oder gleich $2^{K-2}$ und einer kleiner $2^{K-2}$, mit K = Konstraintlänge, Entscheidung erfolgt und aufgrund dieser Entscheidung die Adressierung der Pufferspeicher (PM1,...PM16) vorgenommen wird und im Falle einer Verzweigung im Trellis-Diagramm eine Umwertung der Pfadentscheidungsbits derart erfolgt, daß zwei unterschiedliche Bitmuster entstehen,

- Datenausgabeeinheiten (DA1,...DA16) für die Pufferspeicher (PM1,...PM16), welche von den Minimalmetrikdetektoren (DT2) über von den Adreßprozessoren (DP1,...ADP16) gesteuerte Vermittlungsschalter (SD1,...SD16) schaltbar sind.

3. Dekoder nach Anspruch 2, <u>dadurch gekennzeichnet</u>, daß die Netzwerke zum Vergleich der Zweigmetriken (ACSS1, ... ACSS16) halbarithmetisch aufgebaut sind, daß für jedes Netzwerk die Eingänge für die entgegengesetzten Zweigmetriken auf jeweils eine Additionsstufe (ADS1, ADS2) geführt sind, daß die Ausgänge dieser Additionsstufen (ADS1, ADS2) an Eingänge der Vergleichsstufe (Vn) und an Eingänge eines Metrikselektors (MS) angeschlossen sind, daß der Ausgang der Vergleichsstufe (Vn) mit einem weiteren Eingang des Metrikselektors (MS) verbunden ist, daß dem Metrikselektor (MS) ein Demultiplexer (DMX) nachgeschaltet ist zur Transformation der Metrik in eine Bitposition, und daß die Demultiplexer (DMX) aller Netzwerke (ACSS16, ... ACSS16) auf die Multi-AND-Verknüpfungsstufe (M-AND) geschaltet sind.

4. Einrichtung für einen Viterbi-Dekoder zum Berechnen der Pfadmetriken, wobei die Netzwerke (ACSS1,...ACSS16) ausschließlich mit Bausteinen für den logischen Operationsbereich aufgebaut sind, d.h. mit Netzwerken, die Binärinformationen als Bitposition innerhalb eines $2^n$-zeiligen Bitwortes mit n = Stellenzahl der Binärzahl, zeilenweise logisch miteinander verknüpfen, daß die entgegengesetzten Zweigmetriken auf jeweils eine $2^{K-1}$ breite Shift-Matrix (SH1, SH2) führen, daß jeder Shift-Matrix (SH1, SH2) ein Metrik-Register (MR1, MR2) derart zugeordnet ist, daß die in den Metrik-Registern (MR1, MR2) abgelegten Metrik-Informationen jeweils um genau die Stellenzahl verschoben werden, wie sie jeweils der Betrag der eintreffenden Zweigmetrik vorgibt, daß die Ausgänge beider Shift-Matrizen (SH1, SH2) bitweise auf ein logisches Verknüpfungsgatter (AND16) führen, daß die Ausgänge aller Verknüpfungsgatter an Eingänge einer Multi-AND-Verknüpfungsstufe (M-AND) führen, daß der Prioritätsenkoder (PRE) am Ausgang der Multi-AND-Verknüpfungsstufe (M-AND) mit dem Steuereingang einer weiteren Shift-Matrix (SHM3) am Eingang eines der Metrik-Register (MR2) derart verbunden ist, daß die Information in diesem Metrik-Register (MR2) genau um die Stellenzahl zurückgeschoben wird, die dem vom Prioritätsenkoder (PRE) detektierten Betrag der minimalen Metrik entspricht.

5. Anwendung des Viterbi-Dekoders nach Anspruch 2 für das Verfahren nach Anspruch 1.

6. Anwendung der Einrichtung nach Anspruch 4 für das Verfahren nach Anspruch 1.

## Claims

1. A method of decoding binary signals processed according to an error correcting convolution code, with branch metrics being determined by means of binary operations and path metrics being determined according to Viterbi decoding from said branch metrics for the reception probability of the source data binary signals formed at the encoder, wherein the following steps are employed:

- the path metric exhibiting an extreme value is transformed from the arithmetic to the logic domain of operation in that the binary information of this path metric is represented as a bit position within a bit word having $2^n$ = rows, where n is the number of positions of the binary number;

- the thus processed information is linked by means of logic gates with the remaining path metrics which do not exhibit an extreme value and which are also subjected to such a transformation, this linkage being effected in such a manner that the path metric having the extreme value is subtracted from every one of the remaining path metrics;

- all possible binary signal states occurring at the encoder are simulated in real time, i.e. in synchronism for each clock step, and are each utilized to address a hypothetical source data channel which is fed by the data of the path decision;
- from each hypothetical source data channel, the simulated possible binary signal states at the encoder are actualized for addressing at the same time as a respective buffer memory;
- if there is branching in the trellis diagram of the Viterbi decoding process, the data of the buffer memories whose associated trellis paths did not survive are overwritten by the data of those buffer memories whose associated trellis paths did survive;
- the output of the decoded binary signals from the respective buffer memories is effected according to the correct address by the possible binary signal states at the encoder or, more precisely, by their actualization;
- $2^{K-1}$ different output instruction channels are addressed, where K is the constraint length of the convolution code, with only that output instruction channel performing an output instruction which is associated with the extreme value of the path metric.

2. A Viterbi decoder comprising an input section for making available branch metrics, the input section including a holding circuit with a unit for A/D conversion connected to its output, networks for calculating a path metric from the branch metrics and memories for storing the path metric as well as data output units, characterized by:

- two sample and hold members (SH1, SH2) each having an A/D converter (AD1, AD2) connected to its output for quantizing each bit pair at the input of the decoder, one each multiplexer (MX1, MX2) for the crosswise exchange of data channels at the output of the two A/D converters (AD1, AD2), logic gates (G1, G2, ..., G12) which each receive a control signal (C1, C2) and an output signal from the multiplexers (MX1, MX2), with the logic gates being provided four times per bit word width and being configured, for each bit word width, twice with non-inverting outputs and twice with inverting outputs, and four full adders (ADD1, ..., ADD4) which are linked with the outputs of the logic gates (G1, G2, ..., G12) in such a manner that branch metrics according to the Viterbi decoding process are available at their outputs;
- networks (ACS-S1, ..., ACS-S16) for calculating the path metrics and putting out a path decision bit and for generating an output instruction (DOC) for decoded data, each comprising a comparison stage (Vn; AND16) for opposite branch metrics, path decision bit detectors (DT1) which are connected to the outputs of the comparison stages (Vn; AND16), a return loop from each output of the comparison stages (Vn; AND16) to subtractors (Sub; SHM3) for linkage with a current branch metric, minimum metric detectors (DT2) connected with the return loops for generating the output instructions (DOC);
- a multi-AND linkage stage (M-AND) which receives the preferred metrics of all said networks;
- a priority encoder (PRE) at the output of the multi-AND linkage stage (M-AND) as well as connecting paths from the output of the priority encoder (PRE) to the subtractors (Sub; SHM3) of the networks (ACS-S1, ..., ACS-S16);
- address processors (ADP1, ..., ADP16) having associated address registers (AR1, ..., AR16) for actuating exchange switches (SK1, ..., SK15) in the respective hypothetical source data channel between the networks (ACS-S1, ..., ACS-S16) for a comparison of the branch metrics and the buffer memories (PM1, ..., PM16) configured as FIFO memories or shift registers;
- bidirectional data exchange buses (BL1, ..., BL8) for the respective paired parallel connection of those buffer memories (PM1, ..., PM16) which participate in the overwriting in a trellis branch, with the data exchange buses (BL1, ..., BL8) being switchable by way of exchange switches (SP1, ..., SP16) controlled by address processors (ADP1, ..., ADP16);
- interface circuits (IF1, ..., IF8) between the outputs of every two networks (ACS-S1, ..., ACS-S16) and the address processors (ADP1, ..., ADP16) for recoding the path decision bits furnished by the detectors (DT1) into synchronously occurring hypothetical binary source data that correspond to the data occurring at the encoder, with the recoding taking place in the sense of a decision of greater than or equal to $2^{K-2}$ and a decision of less than $2^{K-2}$, where K is the constraint length, and the buffer memories (PM1, ..., PM16) are addressed on the basis of this decision and, in the case of branching in the trellis diagram, the path decision bits are revalued in such a way that two different bit patterns result;

- data output units (DA1, ..., DA16) for the buffer memories (PM1, ..., PM16), with said data output units being switchable by minimum metric detectors (DT2) via exchange switches (SD1, ..., SD16) controlled by the address processors (ADP1, ..., ADP16).

3. A decoder according to claim 2, characterized in that the networks for comparing the branch metrics (ACS-S1, ..., ACS-S16) are constructed semi-arithmetically; for each network the inputs for the opposite branch metrics are connected with one adder stage (ADS1, ADS2); the outputs of said adder stages (ADS1, ADS2) are connected with inputs of the comparison stage (Vn) and with inputs of a metric selector (MS); the output of the comparison stage (Vn) is connected with a further input of the metric selector (MS); the metric selector (MS) is followed by a connected demultiplexer (DMX) for transforming the metric into a bit position; and the demultiplexers (DMX) of all networks (ACS-S1, ..., ACS-S16) are connected with the multi-AND linkage stage (M-AND).

4. An apparatus for a Viterbi decoder for the calculation of path metrics, wherein the networks (ACS-S1, ..., ACS-S16) are equipped exclusively with modules for the logic domain of operation; that is, with networks that logically link row by row the binary informations as bit positions within a $2^n$-row bit word, where n is the number of positions of the binary number; the opposite branch metrics each lead to a shift matrix (SH1, SH2) which is $2^{K-1}$ wide; each shift matrix (SH1, SH2) has an associated metric register (MR1, MR2) in such a manner that the metric informations stored in the metric registers (MR1, MR2) are each shifted by precisely the number of positions as given by the amount of the incoming branch metric; the outputs of both shift matrixes (SH1, SH2) lead bit by bit to a logic linkage gate (AND16); the outputs of all linkage gates lead to the inputs of a multi-AND linkage stage (M-AND); the priority encoder (PRE) at the output of the multi-AND linkage stage (M-AND) is connected with the control input of a further shift matrix (SHM3) at the input of one of the metric registers (MR2) in such a manner that the information in this metric register (MR2) is shifted back by precisely the number of positions that correspond to the amount of the minimum metric detected by the priority encoder (PRE).

5. Use of the Viterbi decoder according to claim 2 for the method of claim 1.

6. Use of the apparatus according to claim 4 for the method of claim 1.

**Revendications**

1. Procédé pour décoder des signaux binaires préparés selon un code de convolution correcteur d'erreurs, d'après lequel, par des opérations binaires, sont déterminées des métriques de branche et, à partir de celles-ci, des métriques de chemin selon le décodage Viterbi pour la probabilité de réception des signaux binaires de données de base formés côté codeur, avec application des étapes suivantes:

- la métrique de chemin présentant une valeur extrême est amenée par transformation du domaine d'opération arithmétique dans le domaine d'opération logique du fait que l'information binaire de cette métrique de chemin est représentée comme position de bit dans un mot binaire à $2^n$ lignes, où n = le nombre de chiffres ou positions du nombre binaire,

- l'information ainsi préparée est combinée au moyen de portes logiques avec les autres métriques de chemin, ne présentant pas de valeur extrême, qui sont également soumises à une telle transformation, de manière que la métrique de chemin avec la valeur extrême soit déduite de chacune des métriques de chemin restantes,

- tous les états de signal binaire possibles apparaissant côté codeur, sont reproduits en temps réel, c'est-à-dire en même temps pour chaque pas du rythme, et utilisés chaque fois pour l'adressage d'un canal de données de base hypothétiques, lequel est alimenté par les données de la décision de chemin,

- à partir de chaque canal de données de base hypothétiques, sont actualisés simultanément à la fois les états de signal binaire possibles reproduits côté codeur pour l'adressage et, à chaque fois, une mémoire intermédiaire,

- dans le cas d'une ramification dans le diagramme de Trellis du décodage Viterbi, les données des mémoires intermédiaires dont les chemins de Trellis correspondants ne survivent pas, sont recouvertes par les données des mémoires intermédiaires dont les chemins de Trellis correspondants survivent,

- la délivrance des signaux binaires décodés, à partir des mémoires intermédiaires concernées, est effectuée dans la mesure de l'adressage exact par les états de signal binaire possibles, côté codeur, ou de leur actualisation, et

- l'adressage s'opère sur $2^{K-1}$, où K = la longueur de contrainte du code de convolution, différents canaux d'ordre de délivrance dont seul celui coordonné à la valeur extrême de la métrique de chemin exécute chaque fois un ordre de délivrance.

2. Décodeur Viterbi constitué d'une section d'entrée pour la mise à disposition de métriques de branche, qui contient un circuit de maintien avec une unité prévue à la suite pour la conversion A/N, des réseaux pour le calcul d'une métrique de chemin à partir des métriques de branche ainsi que des mémoires pour mémoriser la métrique de branche, ainsi que d'unités de délivrance de données, caractérisé par:

- deux échantillonneurs-bloqueurs (SH1, SH2) suivis chacun d'un convertisseur A/N (AD1, AD2) pour la quantification de chaque paire de bits à l'entrée du décodeur, chaque fois un multiplexeur (MX1, MX2) pour l'interversion croisée des canaux de données à la sortie des deux convertisseurs AN (AD1, AD2), des portes logiques (G1, G2 ... G12), à chacune desquelles sont appliqués un signal de commande (C1, C2) et un signal de sortie des multiplexeurs (MX1, MX2), les portes logiques étant présentes quatre fois par largeur de mot binaire et étant réalisées pour chaque largeur de mot binaire deux fois avec des sorties non inverseuses et deux fois avec des sorties inverseuses, et quatre additionneurs complets (ADD1, ADD4) qui sont combinés aux sorties des portes logiques (G1, G2 ... G12) de manière que les métriques de branche selon le décodage Viterbi soient disponibles à leurs sorties,

- la réalisation des réseaux (ACSS1, ... ACSS16) pour calculer les métriques de chemin et délivrer un bit de décision de chemin, ainsi que pour générer un ordre de délivrance (DOC) de données décodées par chaque fois un étage de comparaison (Vn; ET16) pour des métriques de branche contraires, avec des détecteurs de bit de décision de chemin (DT1) connectés aux sorties des étages de comparaison (Vn; ET16), des boucles de retour menant chaque fois des sorties des étages de comparaison (Vn; ET16) à des soustracteurs (Sub; SHM3) pour la combinaison logique avec une métrique de branche actuelle, ainsi que des détecteurs de métrique minimale (DT2) connectés aux boucles de retour pour la génération des ordres de délivrance (DOC),

- un étage de conjonction ET multiple (M-ET) auquel sont amenées les métriques favorisées de tous les réseaux précités, un codeur de priorité (PRE) à la sortie de l'étage de conjonction ET multiple (M-ET) ainsi que des trajets de liaison menant de la sortie du codeur de priorité (PRE) aux soustracteurs (Sub; SHM3) des réseaux (ACSS1, ... ACSS16),

- des processeurs d'adresse (ADP1, ... ADP16) avec des registres d'adresse (AR1, ... AR16) coordonnés pour l'actionnement de commutateurs (SK1, ... SK15) dans le canal de données de base hypothétiques concerné entre les réseaux (ACSS1, ... ACSS16) en vue de la comparaison des métriques de branche et des mémoires intermédiaires (PM1, ... PM16), réalisées comme des mémoires "premier entré-premier sortie" (FIFO) ou comme des registres à décalage pour les informations de métrique de chemin,

- des bus d'échange de données bidirectionnels (BL1, ... BL8) pour la liaison parallèle par paire des mémoires intermédiaires (PM1, ... PM16) participant au recouvrement de données dans le cas d'une ramification de Trellis, les bus d'échange de données (BL1, ... BL8) étant commutables au moyen de commutateurs (SP1, ... SP16) commandés par des processeurs d'adresse (ADP1, ... ADP16),

- des circuits d'interface (IF1, ... IF8) entre les sorties de chaque fois deux réseaux (ACSS1, ... ACSS16) et les processeurs d'adresse (ADP1, ... ADP16) pour le transcodage des bits de décision de chemin fournis par les détecteurs (DT1) en données de base binaires hypothétiques, apparaissant en même temps pour chaque pas du rythme et correspondant aux données apparaissant côté codeur, le transcodage s'effectuant dans le sens d'une décision entre "supérieur ou égal à $2^{K-2}$" et "inférieur à $2^{K-2}$", où K = la longueur de contrainte, l'adressage des mémoires intermédiaires (PM1, ... PM16) s'effectuant sur la base de cette décision et, dans le cas d'une ramification dans le diagramme de Trellis, un changement de valeur des bits de décision de chemin s'effectuant de manière que soient formées deux configurations binaires différentes, ainsi que

- des unités de délivrance de données (DA1, ... DA16) pour les mémoires intermédiaires (PM1, ... PM16), unités qui sont commutables par les détecteurs de métrique minimale (DT2) au moyen de commutateurs (SD1, ... SD16) commandés par les processeurs d'adresse (ADP1, ... ADP16).

3. Décodeur selon la revendication 2, caractérisé en ce que les réseaux pour comparer les métriques de branche (ACSS1, ... ACSS16) sont de structure semiarithmétique, que les entrées de chaque réseau pour les métriques de branche contraires sont reliées chaque fois à un étage d'addition (ADS1, ADS2), que les sorties de ces étages d'addition (ADS1, ADS2) sont connectées à des entrées de l'étage de comparaison (V1) et à des entrées d'un sélecteur de métrique (MS), que la sortie de l'étage de comparaison (Vn) est reliée à une autre entrée du sélecteur de métrique (MS), que le sélecteur de métrique (MS) est suivi d'un démultiplexeur (DMX) pour la transformation de la métrique en une position de bit et que les démultiplexeurs (DMX) de tous les réseaux (ACSS1, ... ACSS16) sont connectés à l'étage de conjonction ET multiple (M-ET).

4. Dispositif destiné à un décodeur Viterbi pour calculer les métriques de chemin, dans lequel les réseaux (ACSS1, ... ACSS16) sont réalisés exclusivement avec des composants pour le domaine d'opération logique, c'est-à-dire avec des réseaux qui combinent logiquement entre elles, ligne par ligne, des informations binaires sous forme d'une position de bit dans un mot binaire à $2^n$ lignes, où n = le nombre de chiffres ou positions du nombre binaire, que les métriques de branche contraires mènent chaque fois à une matrice de décalage (SH1, SH2) de largeur $2^{K-1}$, qu'un registre de métrique (MR1, MR2) est coordonné à chaque matrice de décalage (SH1, SH2), de manière que les informations de métrique déposées dans les registres de métrique (MR1, MR2) soient décalées chaque fois exactement du nombre de positions préfixé par la valeur de la métrique de branche entrante, que les sorties des deux matrices de décalage (SH1, SH2) mènent, bit par bit, à une porte de combinaison logique (ET16), que les sorties de toutes les portes de combinaison logique mènent à des entrées d'un étage de conjonction ET multiple (M-ET), et que le codeur de priorité (PRE) à la sortie de l'étage de conjonction ET multiple (M-ET) est relié à l'entrée de commande d'une autre matrice de décalage (SHM3), à l'entrée d'un des registres de métrique (MR2), de manière que l'information contenue dans ce registre de métrique (MR2) soit décalée en arrière exactement du nombre de positions correspondant à la valeur de la métrique minimale détectée par le codeur de priorité (PRE).

5. Application du décodeur Viterbi selon la revendication 2 pour le procédé selon la revendication 1.

6. Application du dispositif selon la revendication 4 pour le procédé selon la revendication 1.

**FIG.1**

**FIG.2**

Input 0
Input 1

Zeit

FIG. 3

R₀₀ (bei C1 = C2 = "0")

R₁₀ (bei C₁ = C₂ = "0")

R₀₁ (bei C₁ = C₂ = "0")

R₁₁ (bei C₁ = C₂ = "0")

EP 0 229 246 B1

FIG. 4

M0 → 4 → ADC1 → 16 → |1 0 1 1|

M1 → 4 → ADC2 → 16 → |1 1 0 1|

M15 → 4 → ADCn → 16 → |1 0 1 1| → niedrigste Position

Adreß - Dekoder

n

M-AND

16

|0 0 1 1 0 1 0 1 1| → niedrigste Position

16 → PRE

Prioritäts-Enkoder

4 → „ Min "

EP 0 229 246 B1

FIG. 5

FIG. 6

FIG. 7

PM 1
FIFO, 32 BIT
1 2 4 8  AR1
ADP1
Steuerung

PM2
FIFO
1 2 4 8  AR2
ADP2

ACS-S-WERK

Ausgang
FIFO
1 2 4 8  AR3
ADP3

1 × 32 BIT
Bidirectional
Data-Exchange-Bus

PM 16
FIFO
1 2 4 8  AR16
ADP 16

FIG. 8

EP 0 229 246 B1

| 2S | 2S+1 | EQA | Q(<8) | Q(≥8) |
|----|------|-----|-------|-------|
| 0  | 1    | 0   | 0     | 1     |
| 1  | 0    | 0   | 1     | 0     |

**FIG. 9**

**FIG. 10**

| "New State" (ACS-S Nr.) | 0 | 1 | 2 | 3 | 4 | 5 | 6 | 7 | 8 | 9 | 10 | 11 | 12 | 13 | 14 | 15 | (even↔odd) |
|--------------------------|---|---|---|---|---|---|---|---|---|---|----|----|----|----|----|----|-----------|
| "Old State" (Schiene Nr.) | 0 | 8 | 1 | 9 | 2 | 10 | 3 | 11 | 4 | 12 | 5 | 13 | 6 | 14 | 7 | 15 | (<8↔≥8) |

| 2S | 2S+1 | EQA | Q(<8) | Q(≥8) |
|----|------|-----|-------|-------|
| 0  | 0    | 1   | 0     | 1     |
| 1  | 1    | 1   | 1     | 0     |

> zwangsumgeschaltet

**FIG.11**

Q(<8) ———————— 2S

EXN

EQA

Q(≥8)   (+)   2S+1

EXO

**FIG.12**

| 2S | 2S+1 | EQA | Q(<8) | Q(≥8) | PSI(<8) | PSI(≥8) |
|----|------|-----|-------|-------|---------|---------|
| 0  | 0    | 1   | 0     | 1Z    | 0       | 1       |
| 1  | 1    | 1   | 1     | 0Z    | 1       | 0       |

Identität

**FIG.14**

28

FIG. 13

EP 0 229 246 B1

**FIG.15**

**FIG.16**